# EUROPEAN PATENT APPLICATION

(11) **EP 1 408 556 A2**
(43) Date of publication of application: **14.04.2004**
(21) Application number: 03021463.9
(22) Date of filing: 23.09.2003
(51) Int. Cl.: H01L 31/0203, H01L 31/0232

(54) **Image pickup device and portable terminal equipped therewith**

(30) Priority: 27.09.2002 JP 2002284070; 29.11.2002 JP 2002347349; 29.11.2002 JP 2002347696
(71) Applicant: KONICA CORPORATION, Tokyo (JP)
(72) Inventor: Atarashi, Yuichi, Hachioji-shi, Tokyo 192-8505 (JP); Saito, Masashi, Hachioji-shi, Tokyo 192-8505 (JP); Suzuki, Kazuhiko, Hachioji-shi, Tokyo 192-8505 (JP); Tansho, Kazuo, Hachioji-shi, Tokyo 192-8505 (JP); Nishikawa, Takuo, Hino-shi, Tokyo 191-8511 (JP)
(74) Representative: Henkel, Feiler & Hänzel

(57) **Abstract**

An image pickup device having therein a base board on which an opening portion is formed, an image pickup element that is attached on the reverse side of the base board so that at least a part of the opening portion may be covered, an optical member that is attached to be in contact with the surface of the image pickup element, from the surface side of the base board through the opening portion, and converges incident light on the image pickup element, and an outer frame member that is mounted on the base board to cover the optical member and the opening portion.

## Description

### BACKGROUND OF THE INVENTION

The present invention relates to an image pickup device capable of being equipped on a portable terminal such as a cellphone or a mobile computer and to a portable terminal.

Heretofore, there has been developed a small-sized and high performance image pickup device which can be equipped on an electronic equipment of a small and thin type such as a cellphone and a personal computer. On some of these image pickup devices, an image pickup element provided on a base board and an optical member having a lens for converging on the image pickup element are provided to be united solidly.

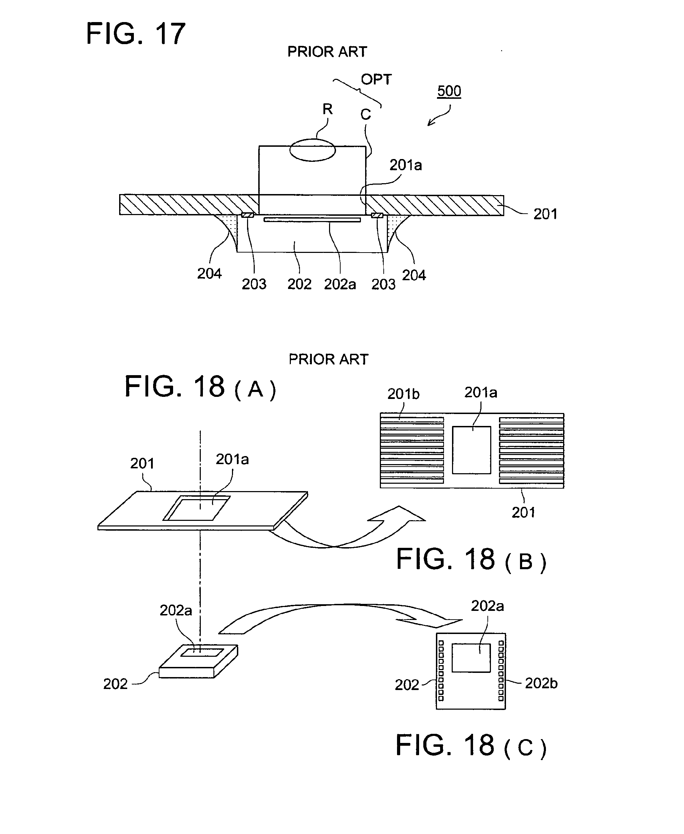

In recent years, with the trend to a thinner electronic equipment, there is known one (for example, Japanese Tokkai No. 2001-292354) having the structure wherein, for making an image pickup device itself to be thinner, opening portion 201a is formed on base board 201 as shown in image pickup device 500 in Fig. 17, for example, and image pickup element 202 is provided on the reverse side of base board 201 so that it covers opening portion 201a, and further, and outer frame body C having optical member R is provided from the surface side of base board PC so that it comes in contact through opening portion 201a, thus, an amount of protrusion of optical element OPT (optical member R, outer frame body C) is lessened by a length equivalent to a thickness of the base board 201.

In Japanese Tokkai No. 2001-292354 stated above, base board 201 is connected electrically to image pickup element 202 through bump 203, as shown in Figs. 18(A) to 18(C). In this bump contact, circuit pattern 201b (bonding pad) that is to be connected to the image pickup element 202 is joined with input and output terminal 202b provided on the image pickup element 202 through bump 203, on the surroundings of opening portion 201a on the base board 201 side.

A method of joining for this bump contact includes, for example, a method to join a metallic terminal with another metallic terminal by means of ultrasonic adhesion and a method to perform electric joining of a contact type by using ACF (anisotropic conductive film) or ACP (anisotropic conductive paste).

In this case, on the portion other than the bump-connected portion, image pickup element 202 is not in close contact with base board 201, and there is formed an air gap (not shown). For preventing that dust or moisture may enter through this air gap, resins 204 such as adhesives are arranged on the entire circumference on the edge portions of the image pickup element 202, and thereby, a clearance between the base board 201 and the image pickup element 202 is sealed.

However, in the case of Japanese Tokkai No. 2001-292354, when fixing the optical element OPT composed of image-forming lens portion R and outer frame body C both united with each other on the image pickup element 202, if there is a manufacturing error, optical performance cannot be attained in terms of focusing. Therefore, it has been necessary to make fine adjustment of a focal point (focus position) after fixing the optical element OPT on the image pickup element 202.

A clearance between base board PC and optical element OPT in mage pickup device 500 has sometimes been generated, causing the condition that dust and moisture (dew condensation) easily enter the clearance. There has been a problem that dust and moisture entered the clearance acted on the image pickup element 202 and affected on image pickup information on the image pickup element 202. Further, there has been another problem that the image-forming lens portion R was easily contaminated or scratched, because the image-forming lens portion R was of a shape to be exposed to the outside.

Incidentally, if a flexible base board is used as a base board, further downsizing of an image pickup device is made possible.

However, in the case of using a flexible base board that is made of an inexpensive and soft polyimide, for example, when an image pickup element is joined with the flexible base board, a temperature of a portion in the vicinity of bump 203 becomes extremely high, resulting from heat generated on a portion of joining, because the coefficient of linear expansion of the flexible base board is greater than that of the image pickup element. Due to this, the flexible base board is distorted, a joining position for the electric contact is deviated, and a shape of the opening portion is deformed. In addition, there is a fear that an edge of the opening portion extends to the position where the edge overlaps with an image pickup area of the image pickup element, or the edge comes in contact with a surface of the image pickup element.

Even after the flexible base board and the image pickup element are joined, a temperature of the image pickup element sometimes rises to be high when the image pickup element is energized, resulting in the occurrence of the same problems as those described above. Therefore, it is impossible to use a flexible base board made of polyimide, and there is considered, in place of the flexible base board made of polyimide, a use of a base board that is made of a material which is close to the image pickup element in terms of the coefficient of linear expansion and is hardly deformed by heat such as, for example, a base board made of ceramic. However, the base board made of ceramic has a problem that it is expensive and is inferior on the point of flexibility compared with one made of polyimide.

In addition, resins 204 arranged to be in contact with the reverse side of base board 201 and with the surface side of image pickup element 202 along the entire circumference on the edge portions of the image pickup element 202 have not contributed to fixing between the base board 201 and the image pickup element 202 in the direction perpendicular to the direction of an optical axis though they have contributed to the fixing in the direction of the optical axis.

Therefore, there has been a fear that, when a load or a shock is applied in the direction perpendicular to the direction of an optical axis, a portion of joining through bump 203 is subjected to concentrated force to be destroyed or deviated because of no portion to resist the load, although the resins 204 is solidification.

### SUMMARY OF THE INVENTION

The first object of the invention is provide an image pickup device having the structure wherein manufacture is easy and troubles are hardly caused on an image pickup element and on an optical member, when the image pickup device is made to be thin.

The second object of the invention is to prevent troubles caused by deformation of a flexible base board resulting from heat in an image pickup device employing the flexible base board.

The third object of the invention is to provide an image pickup device having the structure wherein troubles are hardly caused on a portion of joining between a base board and an image pickup element in the image pickup device.

The objects stated above can be attained by either one of the following Structures (1) - (28).

Structure (1): An image pickup device having therein a base board on which an opening portion is formed, an image pickup element that is attached on the reverse side of the base board so that at least a part of the opening portion may be covered, an optical member that is attached to be in contact with the surface of the image pickup element, from the surface side of the base board through the opening portion, and converges incident light on the image pickup element, and an outer frame member that is mounted on the base board to cover the optical member and the opening portion.

In the invention according to Structure (1), it is possible to make the focusing position of the optical member to be an appropriate position and to attain the prescribed optical function, and thereby to make it unnecessary to adjust the focusing position of the optical member as well as the tilt of the optical member and the image pickup element in the course of and after incorporating, by stabilizing dimensional accuracy of optical members and by incorporating to touch the image pickup element.

In particular, the optical member that converges incident light on the image pickup element is affixed to touch the surface of the image pickup element through the opening portion from the surface side of the base board, for the image pickup element attached on the reverse side of the base board corresponding to the opening portion on the base board, and an outer frame member that covers the optical member and the opening portion of the base board is mounted. Therefore, the image pickup device can be formed to be thinner by an amount equivalent to a thickness of the base board, and image pickup elements corresponding to an optical member and an opening provided on the image pickup device can be protected by the outer frame member, and further, penetration of dust and moisture from the outside of the outer frame member can be prevented and thereby, contamination and scratching of the optical member are prevented.

Therefore, the image pickup device of this kind can be manufactured easily, and it is possible to achieve manufacture wherein troubles of the image pickup device and the optical member are hardly caused.

Structure (2): The image pickup device according to Structure (1), wherein the optical member is provided with a portion to be engaged which is engaged with the outer frame member to prevent that the optical member rotates on the optical axis, and the outer frame member is provided with an engaging portion that engages with the portion to be engaged.

In the invention described in Structure (2), the same effect as in the invention described in Structure (1) can naturally be obtained, and in particular, engagement of the portion to be engaged provided on the optical member with the engaging portion provided on the outer frame member makes the optical member to be engaged with the outer frame member, and positional regulation is conducted so that a rotation of the optical member on the optical axis may be prevented. Therefore, the optical member is hardly moved from the prescribed position, for example, the prescribed position for the image pickup element, which makes it possible to conduct image pickup stably.

Structure (3): The image pickup device according to Structure (1) or (2), wherein the optical member is composed of a first optical member that comes in contact with the surface of the image pickup element and of one or plural auxiliary optical members which are laminated on the first optical member in a way that the optical axis of the first optical member agrees with that of the auxiliary optical member.

In the invention described in Structure (3), the same effect as in the invention described in Structure (1) or (2) can naturally be obtained, and in particular, it is possible to broaden the functions of the optical member by using the first optical member and the auxiliary optical member together, and thereby, by compounding functions as an optical element for the first optical member and the auxiliary optical member. It is therefore possible to structure image pickup devices having various functions.

Structure (4): The image pickup device according to either one of Structures (1) - (3), wherein the base board is provided with electric parts for conducting image processing.

In the invention described in Structure (4), the same effect as in the invention described in either one of Structures (1) - (3) can naturally be obtained, and in particular, the image pickup device can be handled as an image pickup unit and it can easily be provided or replaced on various types of electronic apparatuses, because the base board in the image pickup device is provided with electric parts for conducting image processing.

Structure (5): The image pickup device according to either one of Structures (1) - (4), wherein prescribed electric parts are arranged on the base board covered by the outer frame member.

In the invention described in Structure (5), the same effect as in the invention described in either one of Structures (1) - (4) can naturally be obtained, and in particular, it is possible to cover the prescribed electric parts with the outer frame member and to protect the electric parts from ambient disturbances in the outside of the outer frame member. Thus, it is possible to achieve the structure wherein troubles of electric parts are hardly caused.

Structure (6): The image pickup device according to Structure (4) or (5), wherein at least a part of the electric parts is arranged in the vicinity of the fixed position in the case of fixing the outer frame member on the base board.

In the invention described in Structure (6), the same effect as in the invention described in Structure (4) or (5) can naturally be obtained, and in particular, the outer frame member is guided by the electric parts and can be positioned easily on the base board because at least a part of the electric parts is arranged in the vicinity of the fixed position in the case of fixing the outer frame member on the base board.

Structure (7): The image pickup device according to either one of Structures (1) - (6), wherein a photoelectric conversion portion that converts incident light into an electric signal is provided on the surface of the image pickup element so that it may correspond to the opening, and the optical member is provided so that an image of a subject may be formed when the optical member converges incident light on the photoelectric conversion portion.

In the invention described in Structure (7), the same effect as in the invention described in either one of Structures (1) - (6) can naturally be obtained, and in particular, image pickup can be conducted properly because a photoelectric conversion portion that converts incident light into an electric signal is provided on the surface of the image pickup element so that it may correspond to the opening, and the optical member is provided so that an image of a subject may be formed when the optical member converges incident light on the photoelectric conversion portion.

Structure (8): A portable terminal wherein the image pickup device according to either one of Structures (1) - (7) is provided in a case.

In the invention described in Structure (8), the portable terminal wherein the image pickup device according to either one of Structures (1) - (7) is provided can be made to be thin based on the image pickup device, and can conduct multi functional image pickup based on the image pickup device.

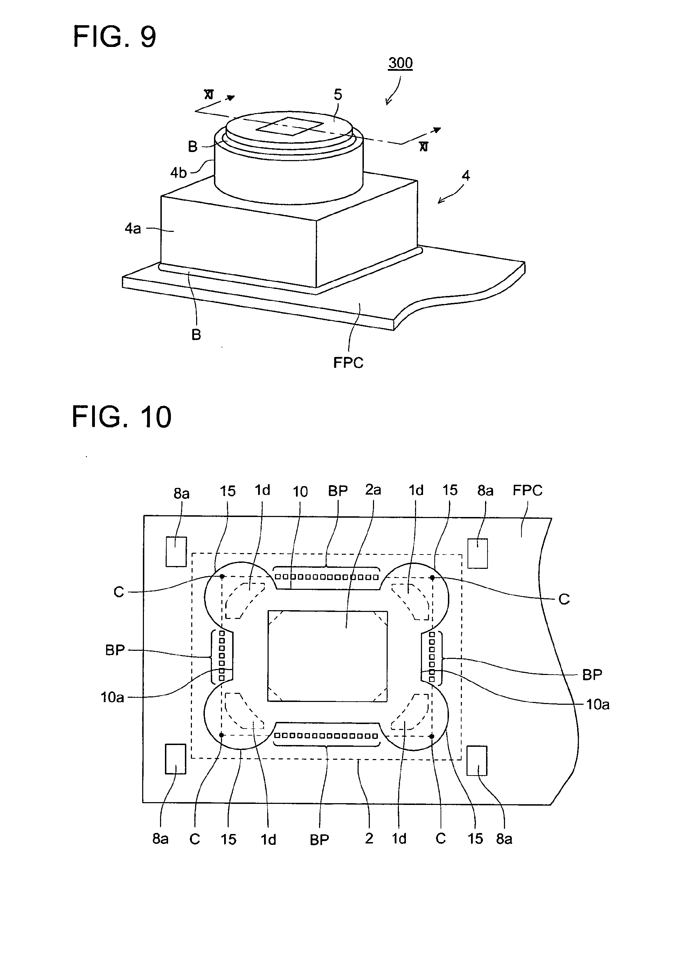

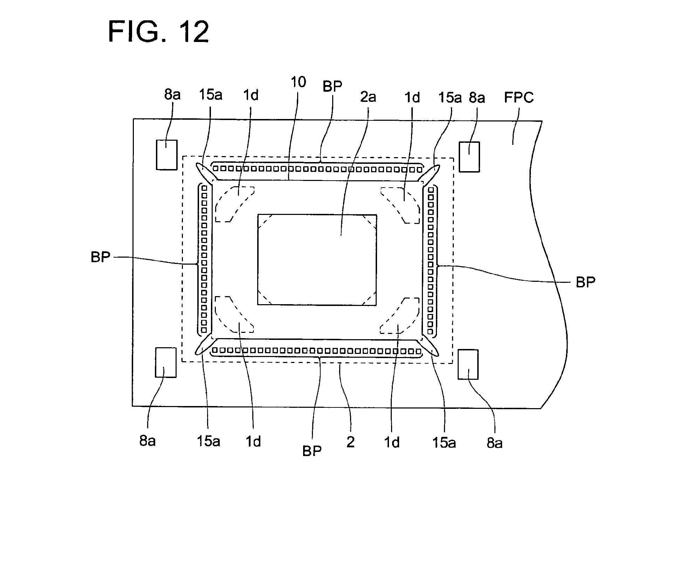

Structure (9): An image pickup device having therein a flexible base board equipped with an opening portion, an image pickup element that is mounted on the reverse side of the flexible base board so that it may cover a part of the opening portion and its image pickup area may be exposed to the outside and an optical member that converges incident light on the image pickup area of the image pickup element, wherein the opening portion is formed in a way that each corner portion of an approximate polygon of the opening portion is cut off (for example, cutout portion 15 shown in Figs. 10 and 12).

In this case, the cutout portion may either be formed simultaneously with the opening portion or be formed after the opening portion is formed.

In the invention described in Structure 9, each corner portion of an approximate polygon of an opening portion is formed to be in a cut-out form, and therefore, when the flexible base board is expanded by its thermal deformation, an amount equivalent to the expansion is absorbed by the cutout portion. Accordingly, it is possible to prevent troubles caused by deformation of a flexible base board including that the flexible base board is distorted, a side edge portion of an opening on the flexible base board comes in contact with a surface of an image pickup element and an image pickup area is covered, in the image pickup device. Thus, even a flexible base board that is easily deformed can also be used, which broadens options for types of the flexible base board.

Structure (10): The image pickup device according to Structure (9), wherein the optical member is mounted so that it comes in contact with a surface side of the image pickup element through the opening portion from a surface side of the flexible base board.

In the invention described in Structure (10), the same effects as those in the invention described in Structure (9) can naturally be obtained, and in particular, the optical member is mounted so that it comes in contact with a surface of the image pickup element through the opening portion, and therefore, dimensional accuracy of the optical member can be stabilized, a focusing position for the optical member can be made to be appropriate one and the prescribed optical functions can be attained, which makes it unnecessary to adjust a focusing position and a tilt of the optical member, in the course of incorporating and after incorporating.

Since the optical member that converges incident light entering the image pickup element is mounted so that the optical member may come in contact with a surface of the image pickup element from the surface side of the base board through the opening portion, for the image pickup element mounted on the reverse side of the base board corresponding to the opening portion on the base board, the image pickup device is formed to be thinner by an amount equivalent to the thickness of the base board, which realizes a thinner image pickup device.

Structure (11): The image pickup device according to Structure (9) or Structure (10), wherein each of four corner portions of an approximate rectangle of an opening portion is formed to be in a cutout form.

In the invention described in Structure (11), the same effects as those in the invention described in Structure (9) or Structure (10) can naturally be obtained, and in particular, each of four corner portions of an approximate rectangle of an opening portion is formed to be in a cut-out form, and therefore, the optical member is mounted so that it comes in contact with a surface of the image pickup element through the opening portion, and therefore, when thermal deformation is caused on the flexible base board, expansions in two directions gather at each of cut out portions for four corners and are absorbed by the cut out portion, which makes it possible to prevent properly the troubles caused by thermal deformation of the flexible base board.

Structure (12): The image pickup device according to either one of Structures (9) - (11), wherein the cutout portion of the opening portion is formed to be tapered off toward the outer edge portion of the flexible base board.

In the invention described in Structure (12), the same effects as those in either one of Structures (9) - (11) can naturally be obtained, and in particular, a cut-out portion on the opening portion is formed to be in a form that is tapered off toward the outer edge portion of the flexible base board, which makes it easy to form a cut-out portion.

Structure (13): The image pickup device according to either one of Structures (10) - (12), wherein the cutout portion of the opening portion is a circular form approximately, and the optical member is structured to touch a surface of the image pickup element through the cutout portion.

In the invention described in Structure (139, the same effects as those in either one of Structures (10) - (12) can naturally be obtained, and in particular, it is possible to make a position of joining for the base board and the image pickup element to be closer to the image pickup area and thereby to make an area other than the image pickup area on the image pickup element to be smaller, because a cut-out portion is in a circular form substantially and the optical member is structured to come in contact with a surface of the image pickup element through the cut-out portion.

Structure (14): The image pickup device according to either one of Structures (9) - (13), wherein the image pickup element and an electric connecting portion are formed along an inner edge portion of the opening portion on the flexible base board.

In the invention described in Structure (14), the same effects as those in either one of Structures (9) - (13) can naturally be obtained, and in particular, a portion of electric connection with the image pickup element is formed along an inner edge portion on the opening portion side of the flexible base board, and thereby, an amount of expansion caused by thermal deformation is absorbed by the cut-out portion, even when thermal deformation is caused on the side edge portion of the opening portion, thus, it is possible to prevent troubles of the image pickup device. It is further possible to prevent deviation of the electric connection portion, because there is no deformation caused by heat supply in the case of connection between the image pickup element and the flexible base board.

Structure (15): The image pickup device according to Structure (14), wherein each cutout portion is formed to be closer to the outer edge side of the flexible base board than a point of intersection of two extended lines of the electric connecting portions formed respectively along adjoining inner edge portions is.

In the invention described in Structure (15), the same effects as those in the invention described in Structure (14) can naturally be obtained, and in particular, a cutout portion is formed to be closer to the outer edge side of the flexible base board than a point of intersection of two extended lines of electric connecting portions formed along adjacent inner edge portions is. Therefore, expansions of the base board can be absorbed more preferably.

Structure (16): The image pickup device according to either one of Structures (9) - (15), wherein a difference between the flexible base board and the image pickup element in terms of the coefficient of linear expansion is 25 - 36 ppm/°C.

In the invention described in Structure (16), the same effects as those in either one of Structures (9) - (15) can naturally be obtained, and in particular, even when using the flexible base board in this range, deformation of the flexible base board can be properly prevented, thus, options for selection of flexible base boards are broadened, and a flexible base board made of polyimide which is more inexpensive and has higher flexibility, for example, can be used.

Structure (17): A portable terminal wherein an image pickup device described in either one of Structures (9) - (16) is housed in a case.

In the invention described in Structure (17), a portable terminal carrying therein the image pickup device described in either one of Structures (9) - (16) can be made small based on the image pickup device.

Structure (18): An image pickup device having therein a base board on which an opening portion is formed, an image pickup element mounted on a reverse side of the base board to cover at least a part of the opening portion and an optical member that converges incident light on the image pickup element, wherein there are provided a connecting member that connects the reverse side of the base board and a surface side of the image pickup element together electrically to be apart each other, and a weir member that is provided to be projected from the surface side of the image pickup element outside the connecting member on the reverse side of the base board, and adhesives are filled in a space between the connecting member and the weir member.

In this case, the connecting member may either be a member provided originally on a base board or an image pickup element, or be one wherein plural members provided on both of the base board and the image pickup element are joined.

Adhesives are resins such as, for example, thermosetting type adhesives, UV-setting type adhesives and heat-UV-setting type adhesives, and the invention is not limited to these resins.

In the invention described in Structure (18), a weir member is provided to be projected from the surface side of the image pickup element on the outside of the connecting member on the reverse side of the base board, and adhesives are filled in a space between the connecting member and the weir member, and therefore, the fixing strength between the base board and the image pickup element is enhanced in both of the direction of an optical axis of the base board and the image pickup element and the direction perpendicular to the direction of an optical axis (hereinafter referred to as vertical direction). Namely, adhesives can be applied not only on the connecting member but also on the weir member, and thereby, an area of adhesion is increased, and strength of adhesion in the vertical direction is increased. Owing to this, even when a load or a shock is applied in the vertical direction, it is possible to prevent that the load is concentrated on the connecting member, namely, the point of joining between bonding pad BP and bump 12, namely, on an electric joining point between the base board and the image pickup element, and it is possible to prevent that the load is concentrated on the electric joining point between the base board and the image pickup element, and thereby, the connecting member is destroyed or troubles are caused on the electric connection.

Structure (19): The image pickup device according to Structure (18), wherein the weir member is provided outside a side end portion of the image pickup element, and the adhesives are filled in a space between the side end portion of the image pickup element and the weir member.

In the invention described in Structure (19), the same effects as those in the invention described in Structure (18) can naturally be obtained, and in particular, adhesives are filled in a space between a side end portion of the image pickup element and the weir member, and thereby, an area of adhesion is increased, and fixing in the direction of an optical axis and fixing in the direction perpendicular to the direction of an optical axis are strengthened.

Structure (20): The image pickup device according to Structure (18) or Structure (19), wherein the weir member is a frame-shaped member, and it is arranged on the base board so that the image pickup element is positioned in the frame.

In the invention described in Structure (20), the same effects as those in the invention described in Structure (18) or Structure (19) can naturally be obtained, and in particular, the weir member is a frame-shaped member and it is arranged on the base board so that an image pickup element is positioned in the frame, thus, adhesives can be filled in the total area outside the image pickup element and thereby, fixing can be strengthened, and manufacturing is easy, compared with an occasion for providing a plurality of weir members.

Structure (21): The image pickup device according to either one of Structures (18) - (20), wherein a length of the weir member in the direction of its projection is shorter than a distance between the reverse side of the base board and the reverse side of the image pickup element.

In the invention described in Structure (21), the same effects as those in the invention described in either one of Structures (18) - (20) can naturally be obtained, and in particular, a length of the projected weir member is shorter than a distance between the reverse side of the base board and the reverse side of the image pickup element, thus, adhesives can be filled in the diagonal direction, which makes it easy to fill.

Structure (22): The image pickup device according to either one of Structures (18) - (21), wherein the optical member is mounted to touch a reverse side of the image pickup element through the opening portion from a surface side of the base board.

In the invention described in Structure (22), the same effects as those in the invention described in either one of Structures (18) - (21) can naturally be obtained, and in particular, the optical member is mounted on the surface side of the base board so that the optical member may come in contact with a surface of the image pickup element through the opening portion, thus, it is possible to stabilize dimensional accuracy of the optical member, and to attain a prescribed optical function by making a focusing position of the optical member to be an appropriated position, thereby, it is possible to make adjustment of focusing position and a tilt for the optical member to be unnecessary in the course of incorporating and after the incorporating.

Further, for the image pickup element mounted on the reverse side of the base board to correspond to the opening portion in terms of position, the optical member that converges incident light on the image pickup element is mounted through the opening portion from the surface side of the base board so that the optical member may touch a surface of the image pickup element. Therefore, the image pickup device can be formed to be thinner by an amount equivalent to a thickness of the base board, which realizes a thinner image pickup device.

Structure (23): The image pickup device according to either one of Structures (18) - (22), wherein the adhesives are represented by either one of UV-setting type adhesives, thermosetting type adhesives and UV-heat setting type adhesives.

In the invention described in Structure (23), the same effects as those in the invention described in either one of Structures (18) - (22) can naturally be obtained, and in particular, an adhesive to be used is either one of a UV-setting type adhesive, a thermosetting type adhesive and a heat-UV-setting type adhesive, which makes it possible to fix the base board and the image pickup element together with adhesives.

Structure (24): A manufacturing method of the image pickup element described in either one of Structures (18) - (23), wherein there are provided a first step to arrange the weir member at the prescribed position on the base board, a second step to mount the image pickup element on the reverse side of the base board through the connecting member so that an image pickup area of the image pickup element may be exposed to the surface side of the base board from the opening portion, a third step to fill in a space between the weir member and the connecting member the adhesives which are set by at least one of heat and ultraviolet rays and a fourth step to set adhesives filled in a space between the weir member and the connecting member with at least either one of heat and ultraviolet rays.

In the invention described in Structure (24), adhesives are filled after the weir member and the image pickup element are mounted on the base board, and therefore, adhesives are interrupted by the weir member not to be filled in unnecessary portions, which is preferable, and adhesives are applied on not only connecting members but also the weir member to increase an area of adhesion, thus, fixing strength between the base board and the image pickup element is enhanced in both of the direction of an optical axis and the direction perpendicular to the direction of an optical axis.

Structure (25): The manufacturing method of the image pickup element described in Structure (24), wherein, in the fourth step, heat or ultraviolet radiation is radiated from a radiating means arranged to be capable of radiating heat or ultraviolet radiation directly on adhesives filled in a space between the base board and the image pickup element through the opening portion from the outside of the opening portion.

In the invention described in Structure (25), the same effects as those in the invention described in Structure (24) can naturally be obtained, and in particular, in the fourth step, heat or ultraviolet radiation is radiated from the radiating means that is arranged so that heat or ultraviolet radiation may be radiated directly to adhesives filled from the outside of the opening portion into a space between the base board and the image pickup element through the opening portion, which makes it possible to harden adhesives without damaging an image pickup area when the image pickup area of the image pickup element is irradiated by heat or ultraviolet radiation.

Structure (26): The manufacturing method of the image pickup element described in Structure (25), wherein filling of adhesives in the third step and radiation of heat or ultraviolet radiation from the radiating means in the fourth step are conducted simultaneously.

In the invention described in Structure (26), the same effects as those in the invention described in Structure (25) can naturally be obtained, and in particular, filling of adhesives in the third step and radiation of heat or ultraviolet radiation from the radiating means in the fourth step are conducted simultaneously, therefore, it is possible to reduce the manufacturing time and to prevent that adhesives flow out to unnecessary portions and adhesives are filled beyond what is necessary.

Structure (27): The manufacturing method of the image pickup element described in Structures (18) - (23), wherein, there are provided a first step to mount the image pickup element on the reverse side of the base board through the connecting member so that an image pickup area of the image pickup element may be exposed to the surface side of the base board from the opening portion, a second step to fill adhesives which are set by at least either one of heat and ultraviolet radiation at the prescribed position between the reverse side of the base board and the surface side of the image pickup element, a third step to set adhesives filled in a space between the base board and the image pickup element by at least either one of heat and ultraviolet radiation for tentative fixing, a fourth step to arrange the weir member at the prescribed position on the base board on the adhesives fixed tentatively and a fifth step to set the adhesives fixed tentatively for regular fixing.

In the invention described in Structure (27), filling of adhesives is easy because the weir member can be arranged after filling adhesives in a space between the base board and the image pickup element for fixing them tentatively.

Structure (28): A portable terminal wherein the image pickup device described in either one of Structures (18) - (23) is housed in a case.

In the invention described in Structure (28), a portable terminal wherein an image pickup device described in either one of Structures (18) - (23) is housed can be made small based on the image pickup device.

### BRIEF DESCRIPTION OF THE DRAWINGS

Fig. 1 is a perspective view showing an image pickup device in Embodiment 1 of the invention.
Fig. 2 is a partially-omitted sectional view showing an image pickup device in Embodiment 1 of the invention.
Fig. 3 is a partially-omitted top view of a base board in an image pickup device related to the invention.
Fig. 4 is a perspective view of an optical member in Embodiment 1 of the invention.
Fig. 5 is a bottom view of an optical member in Embodiment 1 of the invention.
Fig. 6 is a sectional view taken on line VI - VI in Fig. 2.
Fig. 7 is a partially-omitted sectional view showing an image pickup device in Embodiment 2 of the invention.
Fig. 8(a) is a front view and Fig. 8(b) is a rear view, both showing an example of a cellphone equipped with an image pickup device of the invention.
Fig. 9 is a perspective view showing another image pickup device of the invention attaining the second object.
Fig. 10 is a partially omitted top view of the base board in the aforementioned image pickup device relating to the invention.
Fig. 11 is a partially omitted sectional view taken on line XI - XI of the image pickup device shown in Fig. 9.
Fig. 12 is a plan view of the base board for illustrating other examples of a notched portion in the image pickup device of the invention.
Fig. 13 is a partially omitted sectional view of still another image pickup device for attaining the third object taken on line II - II in Fig. 1.
Fig. 14 is a partially omitted top view of the base board in the image pickup device in Fig. 1.
Fig. 15 is a partially omitted sectional view for illustrating a portion of joining between a base board and an image pickup element.
Fig. 16 is an illustration for illustrating a method of hardening adhesives in the image pickup device relating to the invention.
Fig. 17 is a sectional view showing a conventional image pickup device.

Each of Figs. 18(A) - 18(C) is an exploded perspective view showing a conventional image pickup device.

### DETAILED DESCRIPTION OF THE PREFERRED EMBODIMENT

An embodiment of the invention will be explained in detail as follows, referring to drawings.

### (Embodiment 1)

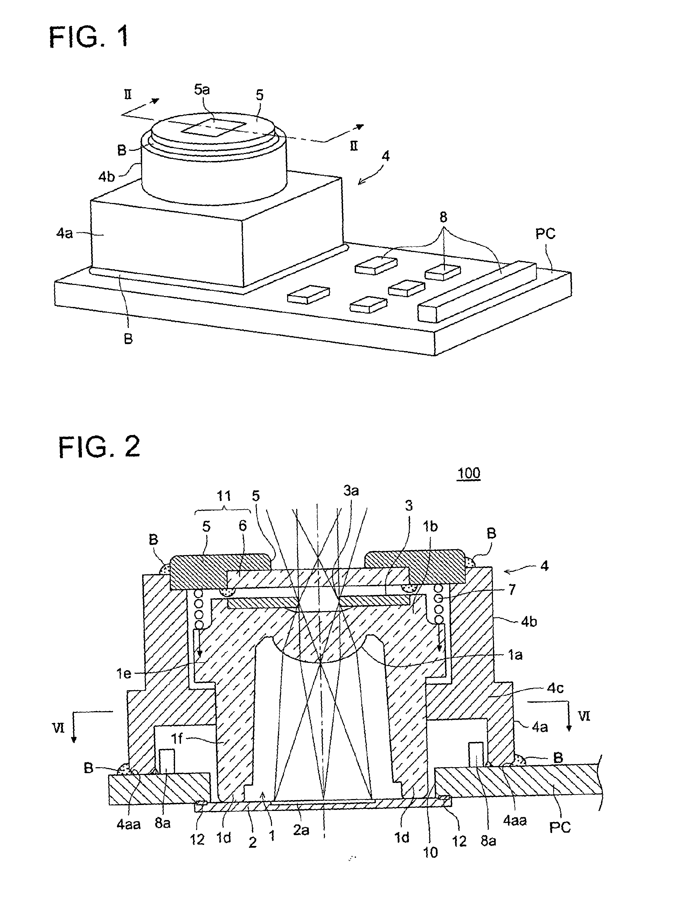

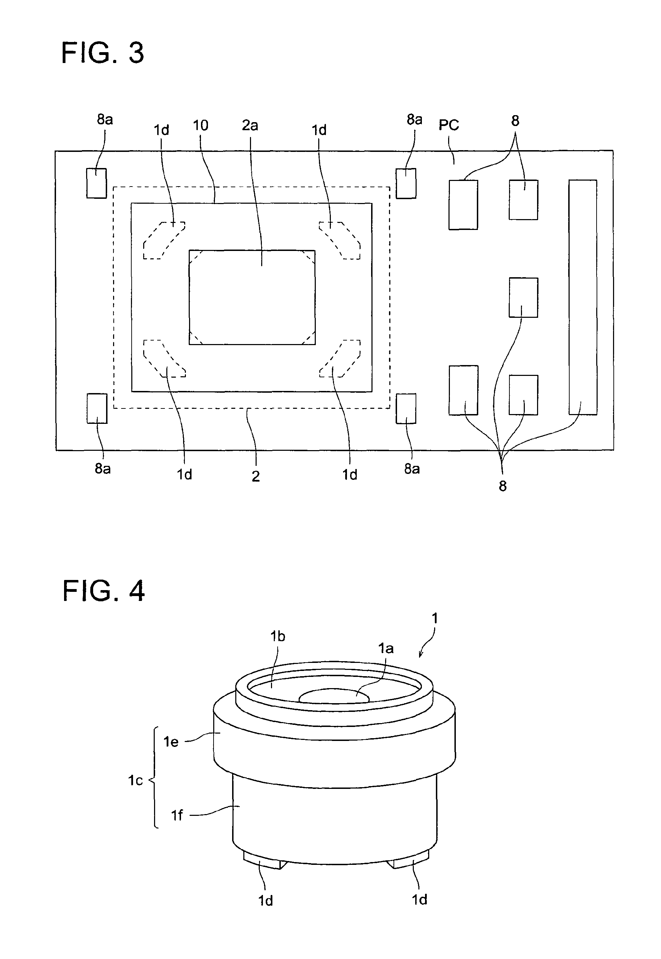

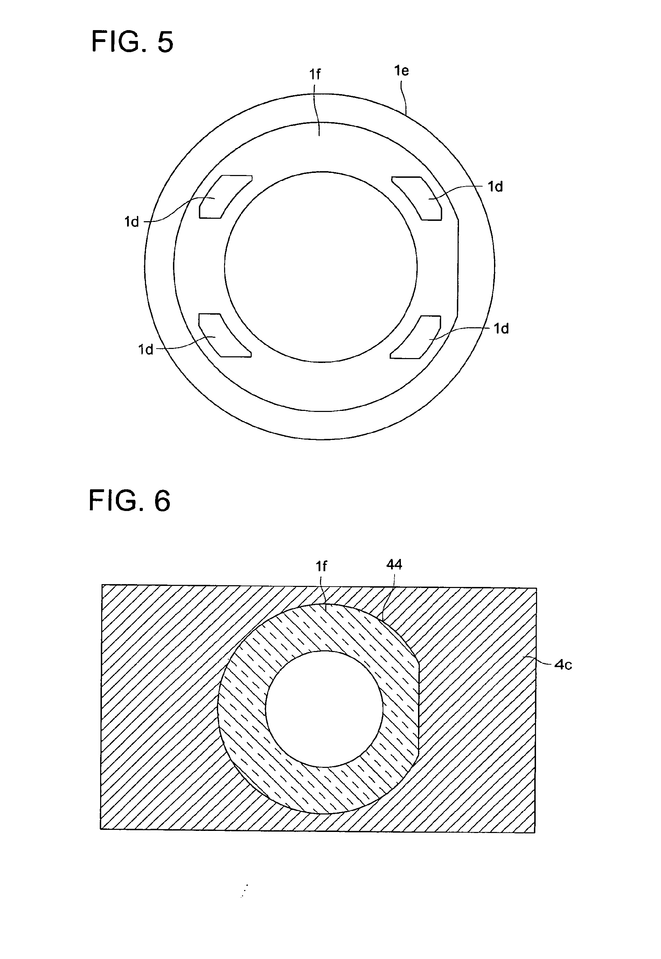

Fig. 1 is a perspective view of image pickup device 100 in the present embodiment, and Fig. 2 is a partially-omitted sectional view of the image pickup device 100 taken on line II - II in Fig. 1. Fig. 3 is a partially-omitted top view of base board P of image pickup device 100. Fig. 4 is a perspective view of optical member 1 provided on image pickup device 100, and Fig. 5 is a bottom view of the optical member 1. Fig. 6 is a sectional view taken on line VI - VI in Fig. 2.

As shown in Figs. 1 - 3, the image pickup device 100 is composed of base board PC on which opening portion 10 is formed, image pickup element 2 provided to cover the opening portion 10 from the rear side of the base board PC, optical member 1 for converging on image pickup element 2 through the opening portion 10 from the surface side of the base board PC by touching a light-intercepting surface representing the surface of the image pickup element 2, diaphragm plate 3 which regulates an amount of light entering the optical member 1, lens frame 4 representing an outer frame member that covers the image pickup element 2 and the opening portion 10, flare plate 5 that is provided on lens frame 4 and has light-shielding property, filter 6 to be supported by the flare plate 5, pressure member 7 that is provided between the flare plate 5 and optical member 1 and presses the optical member 1 toward the base board PC side, positioning electric parts 8a arranged at the prescribed position on the base board PC to conduct positioning of the optical member 1 and of other electric parts 8 arranged on the base board PC.

Image pickup element 2 is composed, for example, of an image sensor of a CMOS type or a CCD type, and an upper face on the edge of the image pickup element 2 in a shape of a rectangular thin plate is attached on the reverse side of base board PC. At the center on the upper face of the image pickup element 2, there are arranged pixels on a two-dimensional basis, and photoelectric conversion portion 2a representing an image pickup surface is formed, so that the photoelectric conversion portion 2a may correspond to the position of the opening portion 10 formed on the base board PC, when the image pickup element 2 is mounted on the reverse side of the base board PC.

An upper face on the edge of the image pickup element 2 is attached on the reverse side of the base board PC through bump 12 that represents an electrode, and thereby, the image pickup element 2 is connected to the base board PC electrically by the bump 12. Incidentally, the image pickup element 2 and the base board PC are attached and connected each other through contact bonding employing ACF (conductive film), welding or soldering.

In the optical member 1, a transparent plastic material is used as a material, and a tubular leg portion 1c and convex-lens-shaped lens portion 1a supported by the leg portion 1c are formed solidly as shown in Fig. 2 and in Figs. 4 - 6. The leg portion 1c is provided with upper leg portion 1e formed around the circumstance on the upper end and with lower leg portion 1f formed between contact portion 1d and the upper leg portion 1e. Lens portion 1a is formed at the center of sheet-shaped upper face portion 1b that covers the top end of the leg portion 1c.

The lower leg portion 1f is substantially in a D-shape that is formed when a circle in a horizontal section is cut by a segment (a chord) connecting two points on a circumference of the circle, and a portion to be engaged is formed.

Diaphragm plate 3 having opening 3a representing a first diaphragm that is made of a light-shielding material and specifies f-number of convex-lens portion 1a is fixed on the top face of upper face portion 1b and on the circumstance of the lens portion 1a, by the use of adhesives.

Outside the optical member 1, there is arranged lens frame 4 that is made of light-shielding material and constitutes an outer frame member. On the lens frame 4, there are provided prismatic lower portion 4a and cylindrical upper portion 4b, as shown in Fig. 1. Light-shielding plate 5 is attached with adhesives B on the top end of upper portion 4b of lens frame 4. The light-shielding plate 5 has opening 5a serving as a second diaphragm on its center. Filter 6 that is made of a material having infrared absorption characteristics is pasted with adhesives B under opening 5a that is located at the center of the light-shielding plate 5. This light-shielding plate 5 and the filter 6 constitute cover member 11.

Lower end portion 4aa of the lower portion 4a is a portion which serves as a sticking area when affixing lens frame 4 on the base board PC, and adhesives B are applied between the lower end portion 4aa of the lower portion 4a and the base board PC for adhesion when the lower portion 4a of the lens frame 4 is brought into contact with and fixed on the base board PC.

Since the base board PC, the lens frame 4 and the cover member 11 are cemented each other on a close contact basis, surfaces of optical member 1 and image pickup element 2 which are covered by the base board PC, the lens frame 4 and the cover member 11 are protected from adhesion of dust and moisture and damages such as scratches which are ambient disturbances.

In a word, the outer frame member that is composed of the lens frame 4 and the cover member 11 covers optical member 1, opening 10 of the base board PC and a surface of image pickup element 2, which means that image pickup device 100 has a dustproof and moisture-proof structure and a structure for protecting optical member 1 and others.

Further, on an inner circumferential surface of partition wall 4c between lower portion 4a and upper portion 4b of lens frame 4, there is formed D-shaped groove 44 serving as an engaging portion corresponding to lower leg portion 1f that is a portion to be engaged of optical member 1, and the lower leg portion 1f is engaged with the D-shaped groove 44 on a close contact basis. Due to this engagement between the lower leg portion 1f and the D-shaped groove 44, the optical member 1 is regulated positionally against the lens frame 4 so that a rotation of the optical member 1 on an optical axis of lens portion 1a thereof may be prevented.

Further, since the optical member 1 is regulated positionally against the lens frame 4, if the lens frame 4 is arranged at prescribed position on the base board PC by positioning based on, for example, positioning electric parts 8a which will be described later, it is possible to arrange the optical member 1 at the prescribed position on the base board PC, so that, for example, the center of photoelectric conversion portion 2a of image pickup element 2 provided on the base board PC may agree with the center of an optical axis of lens portion 1a of the optical member 1 engaged with the lens frame 4.

Further, since the optical member 1 is regulated positionally against the lens frame 4, when the lens frame 4 is arranged at the prescribed position on the base board PC to be fixed, the optical member 1 is hardly shifted from the prescribed position, and for example, a condition where the center of an optical axis of lens portion 1a of the optical member 1 agrees with the center of photoelectric conversion portion 2a of image pickup element 2 can easily be maintained.

In Fig. 2, between the optical member 1 and light-shielding plate 5, there is arranged, for example, pressure member 7 composed of an elastic member such as a coil spring. When the light-shielding plate 5 is mounted on the lens frame 4, the light-shielding plate 5 presses the pressure member 7 and the pressure member 7 is deformed elastically. This pressure member 7 presses the optical member 1 downward in Fig. 2 with prescribed pressure force to urge the optical member 1 against image pickup element 2. When force toward the lower image pickup element 2 is applied from the light-shielding plate 5, the pressure member 7 is deformed to absorb the force to exert a buffer action, which is an effect to block the direct transmission of the force to the image pickup element 2, to prevent damage of the image pickup element 2 and to stabilize the focusing position and the tilt of the optical member and the image pickup element.

Electric parts 8 are electric parts which are necessary to operate image pickup device 100 and to conduct image processing. Since these electric parts 8 are provided on base board PC, the image pickup device 100 can easily be provided on various types of electronic apparatuses as a unit.

Positioning electric parts 8a are represented by, for example, a capacitor, a resistor and a diode as shown in Figs. 2 and 3, and they are arranged to be between the lens frame 4 and opening 10 on base board PC and to correspond positionally to four corners of the lens frame 4 in the vicinity thereof. These positioning electric parts 8a are in the vicinity of the fixing position in the case of fixing the lens frame 4 on the base board PC, and they serve as indicators for positioning of the lens frame 4.
Incidentally, the positioning electric parts 8a have only to be electric parts necessary for image pickup device 100, without being limited, for example, to a capacitor, a resistor and a diode.

Electric parts 8 (for example, electronic parts such as CPU) which need to be protected from ambient disturbance in the outside of the outer frame member composed of lens frame 4 and others among electric parts 8 may be arranged inside the lens frame 4 (outer frame member) such as the positioning electric parts 8a.

As stated above, image pickup element 2 is provided to cover opening 10 on base board PC from the rear side of the base board PC in image pickup device 100, and optical member 1 is provided to come in contact with a light-intercepting surface of the image pickup element 2 through the opening 10 from the surface side of the base board PC. Therefore, it is possible to control protrusion of the optical member 1 from the surface of the base board PC in the normal direction by an amount equivalent to a thickness of the base board PC. Therefore, a thickness of the image pickup device 100 can be made to be thinner by an amount by which the protrusion of the optical member 1 is controlled.

In particular, the optical member 1 and a surface of the image pickup element 2 on which the optical member 1 is provided are covered by an outer frame member such as lens frame 4 and cover member 11, and thereby are protected from adhesion of dust and moisture from the outside of the image pickup device 100 and from damages such as scratches, thus, an influence on image pickup information caused by the state of the optical member 1 and the image pickup element 2 can be eliminated.

Further, since the optical member 1 is engaged with lens frame 4 and is regulated positionally for the lens frame 4, it is possible to provide the optical member 1 by fixing the lens frame 4 at the prescribed position on the base board PC so that the optical member 1 may be at the prescribed position respectively from the base board PC and from the image pickup element 2 provided on the base board PC, and to prevent that the optical member 1 is shifted from the prescribed positions for the base board PC and the image pickup element 2 provided on the base board PC.

### (Embodiment 2)

Next, Embodiment 2 of the invention will be explained as follows. Incidentally, explanation for the same portions as in Embodiment 1 will be omitted, and different portions only will be explained.

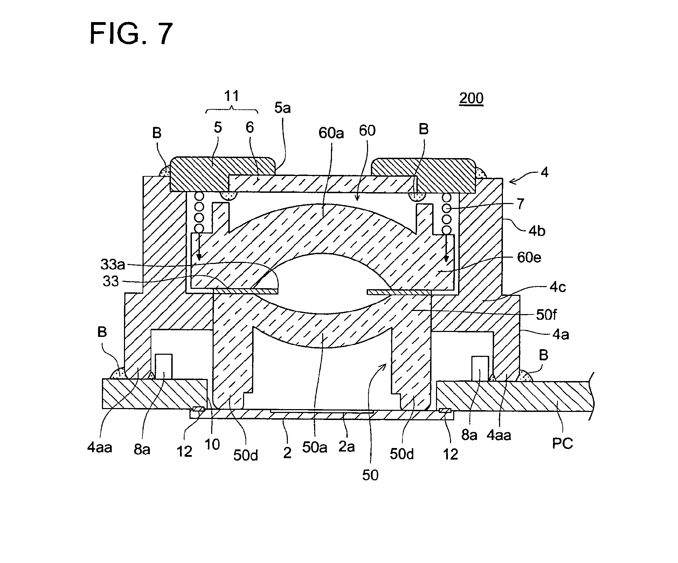

Fig. 7 is a partially-omitted sectional view of image pickup device 200 in Embodiment 2 of the invention.

As shown in Fig. 7, an optical member in image pickup device 200 is composed of first optical member 50 that comes in contact with a surface of image pickup element 2 through opening 10 from the surface side of the base board and of second optical member 60 representing an auxiliary optical member that is provided over the first optical member 50 through diaphragm plate 33 that adjusts an amount of light entering the first optical member 50. Incidentally, an optical axis of the first optical member 50 and that of the second optical member 60 agree each other.

The first optical member 50 is one wherein tubular lower leg portion 50f is provided around lens portion 50a, and on the lower end portion of the lower leg portion 50f, there is provided contact portion 50d that comes in contact with image pickup element 2. Further, an outer circumferential surface of the first optical member 50 is in contact with and is engaged with partition wall 4c of lens frame 4 to ensure positioning of the first optical member 50.

Diaphragm plate 33 having opening 33 that serves as a diaphragm which is made of a material having light-shielding characteristics and specifies f-number of the lens portion 50a is fixed on the top face of the tubular lower leg portion 50f of the first optical member 50 and on a circumference of lens portion 50a, by the use of adhesives.

The second optical member 60 is one wherein tubular upper leg portion 60e is provided on a circumference of lens portion 60a, and diaphragm plate 33 is fixed on a bottom face side of the upper leg portion 60e by adhesives. Further, the second optical member 60 makes pressure member 7 arranged between the second optical member 60 and light-shielding plate 5 to press the second optical member 60 downward in Fig. 7 with prescribed pressing force, and urges the first optical member 50 against image pickup element 2 through diaphragm plate 33.

In the invention described in Structure (3), the same effect as in the invention described in Structure (1) or (2) can naturally be obtained, and in particular, it is possible to broaden the functions of the optical member by using the first optical member 50 and the second optical member 60 by compounding them, and thereby, by compounding functions as an optical element for each of the first optical member 50 and the second optical member 60, in image pickup device 200, as stated above. It is therefore possible to make an image pickup device to be highly functional, despite that the image pickup device is thin.

Next, a portable terminal equipped with the aforementioned image pickup device will be explained as follows, referring to an example of image pickup device 100.

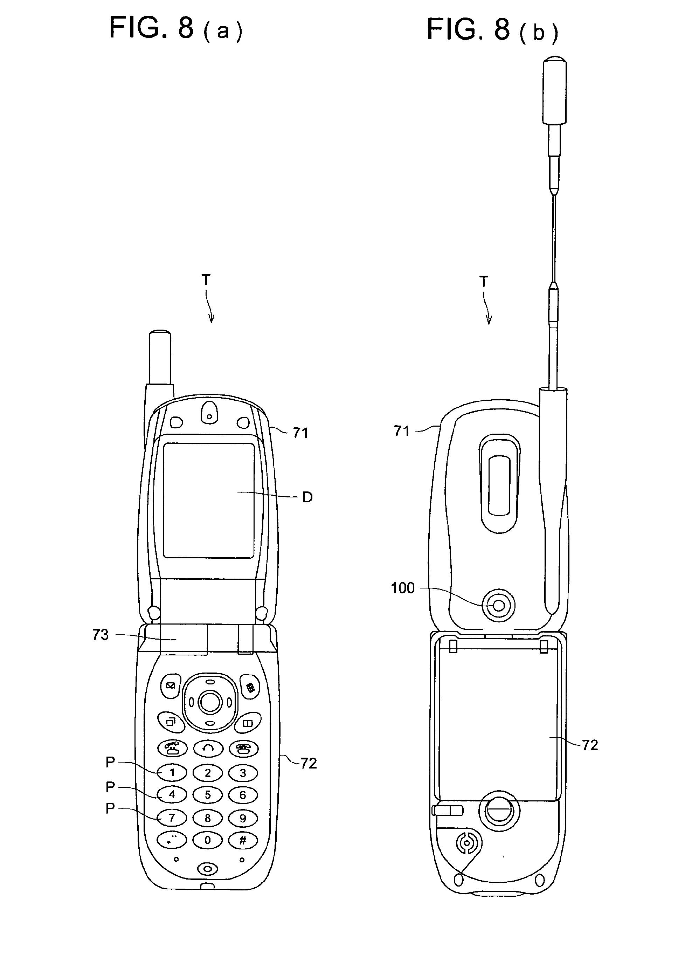

As shown in Figs. 8(a) and 8(b), a portable terminal is, for example, folding cellphone T (hereinafter referred to as cellphone T) wherein upper casing 71 representing a case equipped with display screen D and lower casing 72 equipped with operation buttons P are connected through hinge 73. Image pickup device 100 is housed below the display screen D on an inner surface side (the side having the display screen D) of the upper casing 71, and the image pickup device 100 (optical member 1) is arranged to be capable of taking in light from an outer surface of the upper casing 71. By having thinned image pickup device 100 built-in cellphone T as stated above, it is possible to make the cellphone T to be thinner, and to make it to be a value-added cellphone T by using functions of image pickup device 100 properly depending on a distance from a subject and on image pickup surroundings. Incidentally, an explanation for cellphone T and other constituting factors will be omitted here, because they are widely known.

Incidentally, in the embodiment mentioned above, lower leg portion If representing a portion to be engaged that is formed on optical member 1 is made to be substantially in a D-shape on a section. However, the invention is not limited to this, and other engagement shapes may also be employed.

Further, although image pickup device 200 was explained, referring to an example of two-lens-element structure including the first optical member 50 and the second optical member 60, the number of optical members and that of lens portions are free without being limited to the foregoing, and a shape of lamination layers of plural optical members and a method of lamination are free.

Further, concrete and detailed structures may naturally be modified.

In the invention described in Structure (1), by stabilizing dimensional accuracy of an optical member and by incorporating it to be in contact with an image pickup element, it is possible to make a focusing position of the optical member to be an appropriate position, to attain prescribed optical functions, and to make adjustment about focusing position and the tilt of an optical member to be unnecessary in the course of incorporating and after incorporating.

In particular, for an image pickup element mounted on the reverse side of a base board, corresponding to an opening portion on the base board, an optical member that converges incident light on the image pickup element is installed in a way that the optical member comes in contact with a surface of the image pickup element from the surface side of the base board through the opening portion, and an outer frame member that covers the optical member and the opening portion of the base board is installed. Therefore, the image pickup element can be formed to be thinner by an amount equivalent to a thickness of the base board, the optical member provided on the image pickup device and the image pickup element corresponding to the opening portion can be protected the outer frame member, and entrance of dust and moisture from the outside of the outer frame member and contamination and scratches on the optical member can be prevented.

Accordingly, the image pickup device of this kind can be manufactured easily, and a structure wherein troubles are hardly caused on the image pickup element and the optical member can be realized.

In the invention described in Structure (2), in particular, engagement of the portion to be engaged provided on the optical member with the engaging portion provided on the outer frame member makes the optical member to be engaged with the outer frame member, and positional regulation is conducted so that a rotation of the optical member on the optical axis may be prevented. Therefore, the optical member is hardly moved from the prescribed position, for example, the prescribed position for the image pickup element, which makes it possible to conduct image pickup stably.

In the invention described in Structure (3), in particular, it is possible to broaden the functions of the optical member by using the first optical member and the auxiliary optical member together, and thereby, by compounding functions as an optical element for the first optical member and the auxiliary optical member. It is therefore possible to structure image pickup devices having various functions.

In the invention described in Structure (4), in particular, the image pickup device can be handled as an image pickup unit and it can easily be provided or replaced on various types of electronic apparatuses, because the base board in the image pickup device is provided with electric parts for conducting image processing.

In the invention described in Structure (5), in particular, it is possible to cover the prescribed electric parts with the outer frame member and to protect the electric parts from ambient disturbances in the outside of the outer frame member. Thus, it is possible to achieve the structure wherein troubles of electric parts are hardly caused.

In the invention described in Structure (6), in particular, the outer frame member is guided by the electric parts and can be positioned easily on the base board because at least a part of the electric parts is arranged in the vicinity of the fixed position in the case of fixing the outer frame member on the base board.

In the invention described in Structure (7), in particular, image pickup can be conducted properly because a photoelectric conversion portion that converts incident light into an electric signal is provided on the surface of the image pickup element so that it may correspond to the opening, and the optical member is provided so that an image of a subject may be formed when the optical member converges incident light on the photoelectric conversion portion.

In the invention described in Structure (8), the portable terminal wherein the image pickup device according to either one of Structures (1) - (7) is provided can be made to be thin based on the image pickup device, and can conduct multi functional image pickup based on the image pickup device.

Another embodiment of the invention for attaining the second object will be explained in detail as follows, referring to drawings.

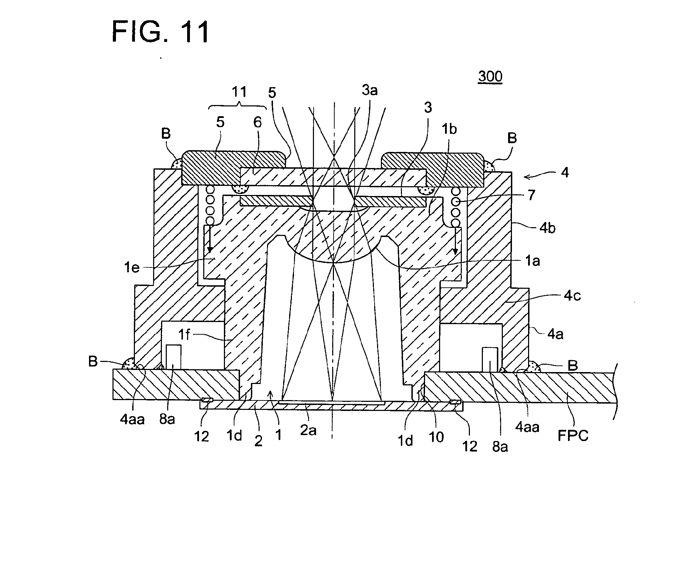

Fig. 9 is a perspective view of image pickup device 300 in the present embodiment, and Fig. 10 is a partially-omitted top view of flexible base board FPC of the image pickup device 300. Fig. 11 is a partially-omitted sectional view of the image pickup device 300 taken on line XI - XI in Fig. 9.

As shown in Fig. 9 - Fig. 11, image pickup device 300 is composed of flexible base board FPC made of polyimide on which opening portion 10 is formed, image pickup element 2 that is provided on the reverse side of the flexible base board FPC to cover the opening portion 10, optical member 1 that is positioned on a surface of the flexible base board FPC to be in contact with a light-receiving surface representing a surface of the image pickup element 2 through the opening portion 10, and converges light on the image pickup element 2, diaphragm plate 3 that regulates an amount of light entering the optical member 1, lens barrel 4 representing an outer frame member that covers the image pickup element 2 and the opening portion 10, light-shielding plate 5 that is provided on the lens barrel 4 and has a light blocking effect, filter 6 supported by the light-shielding plate 5, pressing member 7 that is provided between the light-shielding plate 5 and the optical member 1 and presses the optical member 1 against the flexible base board FPC, positioning electric parts 8a positioned at prescribed locations on the flexible base board FPC for positioning the optical member 1 and others.

The image pickup element 2 is composed, for example, of an image sensor of a CMOS type and an image sensor of a CCD type, and an upper face on the edge portion of the image pickup element 2 is attached on the reverse side of the flexible base board FPC. At the center of an upper face of the image pickup element 2, there are arranged pixels on a two-dimensional basis, and rectangular photoelectric converting portion 2a representing an image pickup area is formed so that the photoelectric converting portion 2a may be exposed from the surface side of the flexible base board FPC when viewed from the position of the opening portion 10 formed on the flexible base board FPC when the image pickup element 2 is attached on the reverse side of the flexible base board FPC.

Further, as shown in Fig. 10, the opening portion 10 on the flexible base board FPC is formed substantially to be a rectangle whose four corners are cut off, and each cut off portion (hereinafter referred to as cutout portion 15) is in a circular form substantially, and is provided at the position corresponding to each of four corners of the photoelectric converting portion 2a of the image pickup element.

An upper face on the edge portion of the image pickup element 2 is mounted on the reverse side of the flexible base board FPC through bump 12 representing an electrode, and the image pickup element 2 is connected electrically to the flexible base board FPC by means of the bump 12.

To be more concrete, bonding pads BP representing electric connecting portions to be connected with the image pickup element 2 are arranged in a way that each group of the bonding pads is in parallel with each of four linear inner edge portions 10a excluding the cutout portions 15 of the opening portion 10 on the flexible base board FPC, as shown in Fig. 10. Each of the bonding pads BP is made of copper, nickel, gold, palladium, alloy of these metals or of those wherein these metals are laminated.

Further, bumps 12 are provided on input and output terminals (not shown) provided respectively at the positions corresponding to the aforementioned bonding pads BP on the outer circumference of photoelectric converting portion 2a, in the image pickup element 2. Thus, the input and output terminals of the image pickup element 2 are joined with bonding pads BP of the flexible base board FPC through the bumps 12, and thereby the image pickup element 2 is connected to the flexible base board FPC electrically. A method of the joining includes, for example, a method of ultrasonic adhesion, and a method of contact bonding employing ACF (anisotropic conductive film) or ACP (anisotropic conductive paste) .

Further, the coefficient of linear expansion of flexible base board FPC made of polyimide is 30 - 40 ppm/°C, for example, and the coefficient of linear expansion of image pickup element 2 made of silicon is 4 - 5 ppm/°C, for example, and the difference between them is about 25 - 36 ppm/°C.

In this case, when a difference in terms of the coefficient of linear expansion between the image pickup element 2 and the flexible base board FPC is great, heat generated when the image pickup element 2 is joined with the flexible base board FPC and heat generated when the image pickup element 2 is energized in the case of using image pickup device 300 cause inner edge portion 10a of opening portion 10 of the flexible base board FPC to expand, but a deformed portion caused by the expansion is absorbed by cutout portion 15. Therefore, it is possible to prevent that deviation is caused on the electric joining point by distortion or deflection resulting from thermal deformation of the flexible base board FPC, and a expanded portion extends to the upper portion of the photoelectric converting portion 2a of the opening portion 10 or it comes in contact with a surface of the image pickup element 2.

In particular, when thermal deformation is caused on a side edge portion of opening portion 10 on the flexible base board FPC, its expanded portion is easily absorbed by cutout portions 15, because bonding points BP are provided along a linear inner edge portion 10a of opening portion 10.

In addition, each cutout portion 15 is cut off so that a circular edge of the cutout portion 15 is closer to the outer edge side of the flexible base board FPC than a point of intersection c of two extended lines of bonding pads BP provided along the inner edge portion 10a is.

Due to this, an amount of expansion of the flexible base board FPC is absorbed surely by the cutout portion 15, which is preferable.

In the optical member 1, a transparent plastic material is used as a material, and a tubular leg portion 1c and convex-lens-shaped lens portion 1a supported by the leg portion 1c are formed solidly as shown in Fig. 11. The leg portion 1c is provided with upper leg portion 1e formed around the circumstance on the upper end and with lower leg portion 1f formed between contact portion 1d and the upper leg portion 1e. Lens portion 1a is formed at the center of sheet-shaped upper face portion 1b that covers the top end of the leg portion 1c. The contact portion 1d is provided at the position corresponding to cutout portion 15 of the flexible base board FPC, and it comes in contact with a prescribed position on image pickup element 2 through the cut-out portion 15.

The lower leg portion 1f is substantially in a D-shape that is formed when a circle in a horizontal section is cut by a segment (a chord) connecting two points on a circumference of the circle, and a portion to be engaged is formed.

Diaphragm plate 3 having opening 3a representing a first diaphragm that is made of a light-shielding material and specifies f-number of convex-lens portion 1a is fixed on the top face of upper face portion 1b and on the circumstance of the lens portion 1a, by the use of adhesives.

Outside the optical member 1, there is arranged lens frame 4 that is made of light-shielding material and constitutes an outer frame member. On the lens frame 4, there are provided prismatic lower portion 4a and cylindrical upper portion 4b, as shown in Fig. 9. Light-shielding plate 5 is attached with adhesives B on the top end of upper portion 4b of lens frame 4. The light-shielding plate 5 has opening 5a serving as a second diaphragm on its center. Filter 6 that is made of a material having infrared absorption characteristics is pasted with adhesives B under opening 5a that is located at the center of the light-shielding plate 5. This light-shielding plate 5 and the filter 6 constitute cover member 11.

Lower end portion 4aa of the lower portion 4a is a portion which serves as a sticking area when affixing lens frame 4 on the flexible base board FPC, and adhesives B are applied between the lower end portion 4aa of the lower portion 4a and the flexible base board FPC for adhesion when the lower portion 4a of the lens frame 4 is brought into contact with and fixed on the flexible base board FPC.

Since the flexible base board FPC, the lens frame 4 and the cover member 11 are cemented each other on a close contact basis, surfaces of optical member 1 and image pickup element 2 which are covered by the flexible base board FPC, the lens frame 4 and the cover member 11 are protected from adhesion of dust and moisture and damages such as scratches which are ambient disturbances.

In a word, the outer frame member that is composed of the lens frame 4 and the cover member 11 covers optical member 1, opening 10 (cut-out portion 15) of the flexible base board FPC and a surface of image pickup element 2, which means that image pickup device 300 has a dustproof and moisture-proof structure and a structure for protecting optical member 1 and others.

Further, since the optical member 1 is regulated positionally against the lens frame 4, if the lens frame 4 is arranged at prescribed position on the flexible base board FPC by positioning based on, for example, positioning electric parts 8a which will be described later, it is possible to arrange the optical member 1 at the prescribed position on the flexible base board FPC, so that, for example, the center of photoelectric conversion portion 2a of image pickup element 2 provided on the flexible base board FPC may agree with the center of an optical axis of lens portion 1a of the optical member 1 engaged with the lens frame 4.

Further, since the optical member 1 is regulated positionally against the lens frame 4, when the lens frame 4 is arranged at the prescribed position on the flexible base board FPC to be fixed, the optical member 1 is hardly shifted from the prescribed position, and for example, a condition where the center of an optical axis of lens portion 1a of the optical member 1 agrees with the center of photoelectric conversion portion 2a of image pickup element 2 can easily be maintained.

In Fig. 11, between the optical member 1 and light-shielding plate 5, there is arranged, for example, pressure member 7 composed of an elastic member such as a coil spring. When the light-shielding plate 5 is mounted on the lens frame 4, the light-shielding plate 5 presses the pressure member 7 and the pressure member 7 is deformed elastically. This pressure member 7 presses the optical member 1 downward in Fig. 11 with prescribed pressure force to urge the optical member 1 against image pickup element 2. When force toward the lower image pickup element 2 is applied from the light-shielding plate 5, the pressure member 7 is deformed to absorb the force to exert a buffer action, which is an effect to block the direct transmission of the force to the image pickup element 2 and to prevent damage of the image pickup element 2.

Positioning electric parts 8a are represented by, for example, a capacitor, a resistor and a diode, and they are arranged to be between the lens frame 4 and opening 10 on flexible base board FPC and to correspond positionally to four corners of the lens frame 4 in the vicinity thereof in Figs. 10 and 11. These positioning electric parts 8a are in the vicinity of the fixing position in the case of fixing the lens frame 4 on the flexible base board FPC, and they serve as indicators for positioning of the lens frame 4. Incidentally, the positioning electric parts 8a have only to be electric parts necessary for image pickup device 300, without being limited, for example, to a capacitor, a resistor and a diode.

Since the image pickup element 2 is provided to cover opening portion 10 on flexible base board FPC from the reverse side of the flexible base board FPC, and optical member 1 is provided to touch photoelectric converting portion 2a of the image pickup element 2 through the opening portion 10 from the surface side of the flexible base board FPC, in image pickup device 300 as stated above, an amount of projection of the optical member 1 from a surface of the flexible base board FPC in the vertical direction can be controlled by an amount equivalent to a thickness of the flexible base board FPC. It is therefore possible to make image pickup device 300 to be thinner by an amount by which the projection of the optical member 1 is controlled.

Further, each of four corner portions of an approximate rectangle of an opening portion 10 on the flexible base board FPC is formed to be in a cutout form, and therefore, when heat is generated when the image pickup element 2 is energized in the course of joining the flexible base board FPC and the image pickup element 2 together, or in the course of usage, and when the heat makes the flexible base board FPC to expand, an amount of the expansion is absorbed by the cutout portion 15. Therefore, it is possible to prevent troubles that the expanded flexible base board FPC covers photoelectric converting portion 2a of the image pickup element 2, and the joined portion is deviated by distortion of the flexible base board FPC.

Further, each cutout portion 15 is formed to be closer to the outer edge side of the flexible base board PFC than point of intersection c of two extended lines of bonding pads BP representing the electric connecting portions is, which is advantageous for thermal deformation caused by joining of the flexible base board FPC and the image pickup element 2 and for energizing of the image pickup element 2.

Further, four contact portions 1d of the optical member 1 are arranged to touch a surface of the image pickup element 2 through cutout portion 15, and therefore, the bonding point BP representing a joining position between the flexible base board FPC and the image pickup element 2 can be formed to be closer to photoelectric converting portion 2a. Therefore, it is possible to make the image pickup element 2 itself to be smaller by making an area of the image pickup element 2 other than the photoelectric converting portion 2a to be smaller, thus, the image pickup device 300 and a portable terminal housing therein the image pickup device 300 (for example, folding cellphone T) can be downsized.

Since the optical member 1 and a surface of the image pickup element 2 in which the optical member 1 is provided are covered by an outer frame member such as lens barrel 4 and cover member 11, the optical member 1 and the image pickup element 2 are prevented and protected from sticking of dust and moisture coming from the outside of the image pickup device 300 and from damage such as cracks, thus, it is possible to eliminate an influence on image pickup information resulting from the conditions of the optical member 1 and the image pickup element 2.

Further, since the optical member 1 is fitted in the lens barrel 4 and is regulated in terms of a position, it is possible to provide the optical member 1 so that prescribed positioning can be conducted for the flexible base board FPC and for the image pickup element 2 provided on the flexible base board FPC, based on fixation of the lens barrel 4 at the prescribed position on the flexible base board FPC, and it is possible to prevent that the optical member 1 is deviated from prescribed positions of the flexible base board FPC and of the image pickup element 2 provided on the flexible base board FPC.

Incidentally, the opening portion 10 is assumed to be in a shape wherein each corner portion of an approximate polygon is cut off, although it has been explained as a shape wherein each of four corner portions a rectangle is cut off in the embodiment stated above.

Though the cutout portion 15 is made to be in a circular form substantially, the invention is not limited to this, and the cutout portion 15 may take any form on condition that the form can absorb thermal deformation of the flexible base board FPC. For example, the form may also be one that is tapered off toward the outer edge portion of the flexible base board FPC (cutout portion 15a) as shown in Fig. 12. In this case, the cutout portion 11a can be formed easily.

In addition, the number of the cutout portion 15 is not limited to four.

Further, lower leg portion 1f representing a portion to be fit that is formed on optical member 1 is made so that its section is in a D-shaped form substantially. However, the invention is not limited to this, and other shapes for fitting can also be used.

In addition, it is naturally possible to modify the specific and detailed structures according to circumstances.

In the invention described in Structure (9), each corner portion of an approximate polygon of an opening portion is formed to be in a cut-out form, and therefore, when the flexible base board is expanded by its thermal deformation, an amount equivalent to the expansion is absorbed by the cutout portion. Accordingly, it is possible to prevent troubles caused by deformation of a flexible base board including that the flexible base board is distorted, a side edge portion of an opening on the flexible base board comes in contact with a surface of an image pickup element and an image pickup area is covered, in the image pickup device. Thus, even a flexible base board that is easily deformed can also be used, which broadens options for types of the flexible base board.

In the invention described in Structure (10), in particular, the optical member is mounted so that it comes in contact with a surface of the image pickup element through the opening portion, and therefore, dimensional accuracy of the optical member can be stabilized, a focusing position for the optical member can be made to be appropriate one and the prescribed optical functions can be attained, which makes it unnecessary to adjust a focusing position and a tilt of the optical member, in the course of incorporating and after incorporating.

Since the optical member that converges incident light entering the image pickup element is mounted so that the optical member may come in contact with a surface of the image pickup element from the surface side of the base board through the opening portion, for the image pickup element mounted on the reverse side of the base board corresponding to the opening portion on the base board, the image pickup device is formed to be thinner by an amount equivalent to the thickness of the base board, which realizes a thinner image pickup device.

In the invention described in Structure (11), in particular, each of four corner portions of an approximate rectangle of an opening portion is formed to be in a cut-out form, and therefore, the optical member is mounted so that it comes in contact with a surface of the image pickup element through the opening portion, and therefore, when thermal deformation is caused on the flexible base board, expansions in two directions gather at each of cut out portions for four corners and are absorbed by the cut out portion, which makes it possible to prevent properly the troubles caused by thermal deformation of the flexible base board.

In the invention described in Structure (12), in particular, a cut-out portion on the opening portion is formed to be in a form that is tapered off toward the outer edge portion of the flexible base board, which makes it easy to form a cut-out portion.

In the invention described in Structure (13), in particular, it is possible to make a position of joining for the base board and the image pickup element to be closer to the image pickup area and thereby to make an area other than the image pickup area on the image pickup element to be smaller, because a cut-out portion is in a circular form substantially and the optical member is structured to come in contact with a surface of the image pickup element through the cut-out portion.

In the invention described in Structure (14), in particular, a portion of electric connection with the image pickup element is formed along an inner edge portion on the opening portion side of the flexible base board, and thereby, an amount of expansion caused by thermal deformation is absorbed by the cut-out portion, even when thermal deformation is caused on the side edge portion of the opening portion, thus, it is possible to prevent troubles of the image pickup device. It is further possible to prevent deviation of the electric connection portion, because there is no deformation caused by heat supply in the case of connection between the image pickup element and the flexible base board.

In the invention described in Structure (15), in particular, a cutout portion is formed to be closer to the outer edge side of the flexible base board than a point of intersection of two extended lines of electric connecting portions formed along adjacent inner edge portions is. Therefore, expansions of the base board can be absorbed more preferably.

In the invention described in Structure (16), in particular, even when using the flexible base board in this range, deformation of the flexible base board can be properly prevented, thus, options for selection of flexible base boards are broadened, and a flexible base board made of polyimide which is more inexpensive and has higher flexibility, for example, can be used.

In the invention described in Structure (17), a portable terminal carrying therein the image pickup device described in either one of Structures (9) - (16) can be made small based on the image pickup device.

Still another embodiment of the invention for attaining the third object will be explained in detail as follows, referring to the drawings.

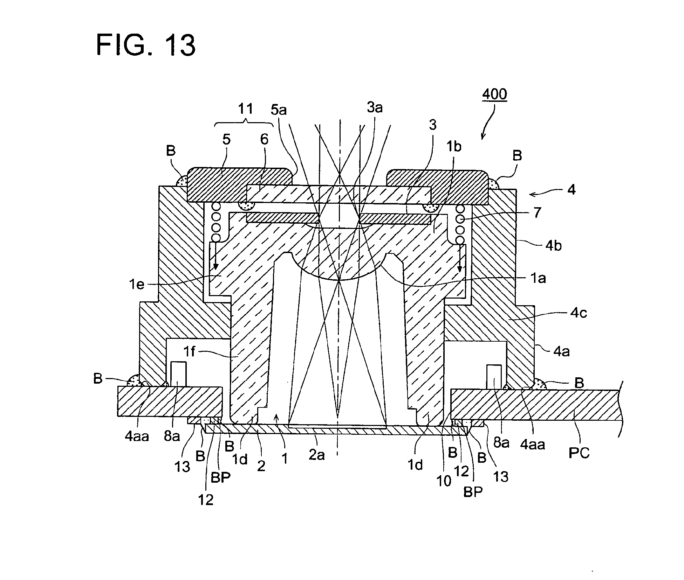

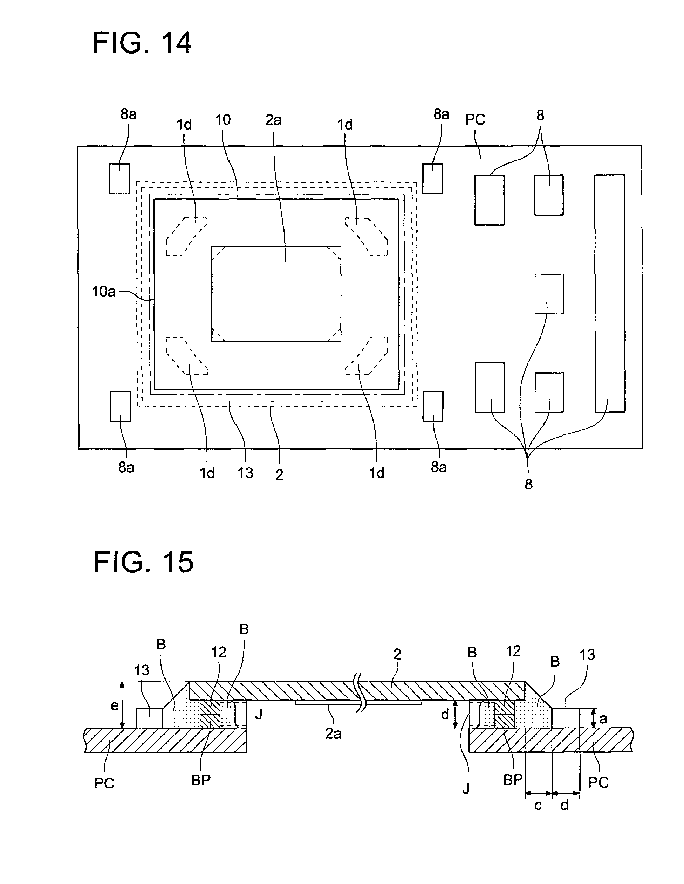

Fig. 13 is a partially omitted sectional view of image pickup device 400 taken on line II - II in Fig. 1, and Fig. 14 is a partially omitted top view of base board PC of image pickup device 400. Fig. 15 is a partially omitted enlarged sectional view for explaining a joining portion between base board PC and image pickup element 2. Incidentally, Fig. 5 is in an upside-down direction for Figs. 1, 13 and 14.

As shown in Figs. 1, and 13 to 15, image pickup device 400 is composed of base board PC on which opening portion 10 is formed, image pickup element 2 that is provided on the reverse side of the base board PC to cover the opening portion 10, optical member 1 that is positioned on a surface of the base board PC to be in contact with a light-receiving surface representing a surface of the image pickup element 2 through the opening portion 10, and converges light on the image pickup element 2, diaphragm plate 3 that regulates an amount of light entering the optical member 1, lens barrel 4 representing an outer frame member that covers the image pickup element 2 and the opening portion 10, light-shielding plate 5 that is provided on the lens barrel 4 and has light tightness, filter 6 supported by the light-shielding plate 5, pressing member 7 that is provided between the light-shielding plate 5 and the optical member 1 and presses the optical member 1 against the base board PC, positioning electric parts 8 arranged at prescribed locations on the base board PC for positioning the optical member 1 and other electric parts 8 arranged on the base board PC.

The image pickup element 2 is composed, for example, of an image sensor of a CMOS type and an image sensor of a CCD type, and an upper face on the edge portion of the image pickup element 2 is attached on the reverse side of the base board PC. At the center of an upper face of the image pickup element 2, there are arranged pixels on a two-dimensional basis, and rectangular photoelectric converting portion 2a representing an image pickup area is formed in a way that the photoelectric converting portion 2a can be viewed from the surface side of the base board PC through the opening portion 10 formed on the base board PC when the image pickup element 2 is attached on the reverse side of the base board PC.

An upper face on the edge portion of the image pickup element 2 is mounted on the reverse side of the flexible base board FPC through bump 12 representing an electrode, and the image pickup element 2 is connected electrically to the base board PC by means of the bump 12.

To be more concrete, bonding pads BP representing electric connecting portions to be connected with the image pickup element 2 are arranged to be in parallel to inner edge portion 10a of the opening portion 10 on the base board PC, as shown in Fig. 13 and Fig. 15. Each of the bonding pads BP is made of copper, nickel, gold, palladium, alloy of these metals or of those wherein these metals are laminated.

Further, bumps 12 (connecting members) are provided on input and output terminals (not shown) provided respectively at the positions corresponding to the aforementioned bonding pads BP on the outer circumference of photoelectric converting portion 2a, in the image pickup element 2. Thus, the input and output terminals of the image pickup element 2 are joined with bonding pads BP of the base board PC through the bumps 12, and thereby the image pickup element 2 is connected to the base board PC electrically. A method of the joining includes, for example, a method of ultrasonic adhesion, and a method of contact bonding employing ACF (anisotropic conductive film) or ACP (anisotropic conductive paste) .

As shown in Figs. 1 and 13-14, on the reverse side of the base board PC, there is provided, for example, frame-shaped weir member 13 that is made of polyimide so that it surrounds an outer side of the image pickup element 2.

As shown in Figs. 15, adhesives B are filled in a room from side end portion 2b of the image pickup element 2 to the position up to the height of the weir member 13 substantially, in a space between the weir member 13 and portion of joining J (connecting member) that is formed when bonding pad BP and bump 12 are joined together.

The adhesives B are resins which can be hardened when conducting heating of the glued portion, applying of ultraviolet rays on the glued portion or other means, or when conducting the foregoing on a combined basis, and the adhesives include ordinary thermosetting type adhesives, UV-setting type adhesives, heat-UV-setting type adhesives and composite-setting type adhesives.

More specifically, as heat-UV-setting type adhesives (resins) which can be hardened by irradiation of any of heat and ultraviolet rays, there are given, for example, Three-bond 3012 (registered trade mark) and World-lock No. 863 (registered trade mark). As composite-setting type adhesives which can be hardened by hardening agents or hardening-promoting agents as other means and also can be hardened even by UV irradiation, there is given Three-bond 3006 (registered trade mark) employing Three-bond 3095 (registered trade mark) as hardening-promoting agents.

In Fig. 15, let it be assumed that "a" represents a length (height of the weir member 13) by which the weir member 13 is projected toward the image pickup element 2, "b" represents a width of the weir member 13, "c" represents a length that is a distance from the weir member 13 to the outer end portion of the image pickup element 2, "d" represents a distance between the base board PC and the image pickup element 2, namely, a length of the portion of joining J and "e" represents a length that is a distance from the reverse side of the base board PC to the reverse side of the image pickup element 2. In Fig. 4, height "a" of the weir member is not less than distance "c" between the weir member 13 and the image pickup element 2, and "c" is greater than 0.1. The reason for this is to provide a sufficient distance, considering manufacturing errors for the weir member 13 itself and errors in sticking on the base board PC.

Height "a" of the weir member 13 is greater than length "d" of the portion of joining J that is a distance between the base board PC and the image pickup element 2. Due to this, the portion of joining J can be protected from a shock in the direction perpendicular to the optical axis. Further, width "b" of the weir member 13 is greater than height "a" of the weir member. Due to this, fixing of the weir member 13 on the base board PC is stabilized. Height "a" of the weir member 13 is smaller than length "e" for the distance between the reverse side of the base board PC and the reverse side of the image pickup element 2, and thereby, adhesives B can be filled in the diagonal direction, which makes it easy to fill.

When adhesives B are filled in a space between the weir member 13 and the portion of joining J, functions of dustproof and moisture-proof to prevent dust and moisture from entering from the outside, are fulfilled. In addition to this, the strength of fixing between the base board PC and the image pickup element 2 in both of the direction of an optical axis and the direction perpendicular to the direction of an optical axis (hereinafter referred to as vertical direction) is increased.

Namely, adhesives can be applied not only on the portion of joining but also on the weir member 13, and thereby, an area of adhesion is increased and strength of adhesion in the vertical direction is increased. Owing to this, even when a load or a shock is applied in the vertical direction, it is possible to prevent that the load is concentrated on the portion of joining J between bonding pad BP and bump 12, namely, on an electric joining point between the base board PC and the image pickup element 2, and the portion of joining J is deviated or troubles are caused on the electric connection.

Further, owing to that adhesives B are filled in a room from side end portion 2b of the image pickup element 2 to the position up to the height of the weir member 13 substantially, an area of adhesion is increased, and thereby, fixing in both the direction of an optical axis and the vertical direction is strengthened.

Even on the portion of joining J between bonding pad BP and bump 12 closer to photoelectric converting portion 2a, adhesives B are filled in a space between the base board PC and the image pickup element 2. It is therefore possible to prevent that moisture or dust enters the photoelectric converting portion 2a or a contact portion between optical member 1 and the image pickup element 2, from opening portion 10.

A filling method and a hardening method for the adhesives B will be described later.

In the optical member 1, a transparent plastic material is used as a material, and a tubular leg portion 1c and convex-lens-shaped lens portion 1a supported by the leg portion 1c are formed solidly as shown in Fig. 13 and in Figs. 4 - 6. The leg portion 1c is provided with upper leg portion 1e formed around the circumstance on the upper end and with lower leg portion 1f formed between contact portion 1d and the upper leg portion 1e. Lens portion 1a is formed at the center of sheet-shaped upper face portion 1b that covers the top end of the leg portion 1c. The contact portion 1d comes in contact with a prescribed position on image pickup element 2 through opening portion 10 of base board PC.

The lower leg portion 1f is substantially in a D-shape that is formed when a circle in a horizontal section is cut by a segment (a chord) connecting two points on a circumference of the circle, and a portion to be engaged is formed.

Diaphragm plate 3 having opening 3a representing a first diaphragm that is made of a light-shielding material and specifies f-number of convex-lens portion 1a is fixed on the top face of upper face portion 1b and on the circumstance of the lens portion 1a, by the use of adhesives.

Outside the optical member 1, there is arranged lens frame 4 that is made of light-shielding material and constitutes an outer frame member. On the lens frame 4, there are provided prismatic lower portion 4a and cylindrical upper portion 4b, as shown in Fig. 1. Light-shielding plate 5 is attached with adhesives B on the top end of upper portion 4b of lens frame 4. The light-shielding plate 5 has opening 5a serving as a second diaphragm on its center. Filter 6 that is made of a material having infrared absorption characteristics is pasted with adhesives B under opening 5a that is located at the center of the light-shielding plate 5. This light-shielding plate 5 and the filter 6 constitute cover member 11.

Lower end portion 4aa of the lower portion 4a is a portion which serves as a sticking area when affixing lens frame 4 on the base board PC, and adhesives B are applied between the lower end portion 4aa of the lower portion 4a and the base board PC for adhesion when the lower portion 4a of the lens frame 4 is brought into contact with and fixed on the base board PC.

Since the base board PC, the lens frame 4 and the cover member 11 are cemented each other on a close contact basis, surfaces of optical member 1 and image pickup element 2 which are covered by the base board PC, the lens frame 4 and the cover member 11 are protected from adhesion of dust and moisture and damages such as scratches which are ambient disturbances.

In a word, the outer frame member that is composed of the lens frame 4 and the cover member 11 covers optical member 1, opening 10 of the base board PC and a surface of image pickup element 2, which means that image pickup device 400 has a dustproof and moisture-proof structure and a structure for protecting optical member 1 and others.

Next, a method of fixing for the base board PC and the image pickup element 2, in particular, among manufacturing methods for the image pickup device 400 will be explained.

First, the adhesives B are coated at an appropriate position on the reverse side of the base board PC to stick the weir member 13.

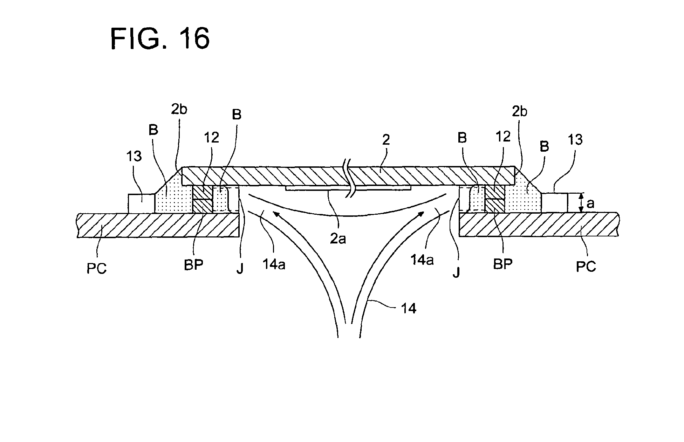

Then, the adhesives B are filled from the opening portion between side end portion 2b of the image pickup element 2 and the weir member 13, and simultaneously with this, the adhesives B thus filled are hardened by heating device 14 (irradiation means) such as an electric heater, for example, shown in Fig. 16 through heating from outlets 14a and 14a which are formed to be forked on the heating device 14. Thus, the fixing processing for the base board PC and the image pickup element 2 is completed. Incidentally, in the same way as in Fig. 15, Fig. 16 is seen upside down against Figs. 1, 13 and 14.

In this case, the forked outlets 14a and 14a of the heating device 14 are in the form in which heating can be conducted (heat can be irradiated) in the direction that is almost in parallel with a surface of the image pickup element 2. Namely, the forked outlets 14a and 14a of the heating device 14 are arranged so that adhesives B can be heated directly from the outside of opening portion 10 through the opening portion 10. Therefore, it is prevented that photoelectric converting portion 2a is heated and damaged, which is preferable. It is further possible to prevent that adhesives B flow out to unnecessary portions such as photoelectric converting portion 2a while they are filled and hardened simultaneously.

Incidentally, outlets 14a of the heating device 14 are not limited to the forked shape, and it is also possible that a plurality of outlets 14 are provided and hardening processing for plural locations are conducted simultaneously. In this case, the time required for hardening processing can be shortened and hardening can be conducted under the same conditions for temperature and time, resulting in realization of uniform fixing, which is preferable.

With respect to hardening processing of the adhesives B, the adhesives B may also be UV-setting type adhesives and heat-UV-setting type adhesives in addition to ordinary thermosetting type adhesives. In this case, it is also possible to employ the structure wherein a UV-irradiating device (not shown) is used in place of heating device 14, or together with the heating device 14 to irradiate the position for filling adhesives B for hardening the adhesives B. Further, even in the case of a UV-irradiating device (not shown), it is also possible to employ the structure wherein the ultraviolet rays do not hit photoelectric converting portion 2a as in the case of the heating device 14, namely, the structure wherein plural irradiating outlets for ultraviolet rays are provided and it is possible to irradiate in the direction that is in parallel with the photoelectric converting portion 2a.

As stated above, the image pickup element 2 is provided so that it covers opening portion 10 on base board PC from the reverse side of the base board PC, and the optical member 1 is provided so that it touches photoelectric converting portion 2a of the image pickup element 2 through opening portion 10 from the surface side of the base board PC, in image pickup device 400, which makes it possible to control the projection of the optical member 1 in the vertical direction from a surface of the base board PC by an amount equivalent to the thickness of the base board PC. Therefore, a thickness of the image pickup device 400 can be made thinner by an amount by which the projection of the optical member 1 is controlled.

Further, dustproof and moisture-proof functions which can prevent entry of dust and moisture from the outside are performed by weir member 13 provided and adhesives B filled in the circumference of joining portion J between the base board PC and the image pickup element 2. In addition to this, the strength of fixation between the base board PC and the image pickup element 2 is increased both in the direction of an optical axis for the base board PC and the image pickup element 2 and the direction perpendicular to the direction of an optical axis (hereinafter referred to as vertical direction). Namely, adhesives adhere not only to the joining portion but also to the weir member to increase an adhesion area, and thereby, the strength of adhesion in the vertical direction is increased. Due to this, it is possible to prevent that loads are concentrated on the joining portion J between bonding pad BP and bump 12, namely, on the electric joining point between the base board PC and the image pickup element 2, and the joining portion J is deviated and troubles are caused on the electric connection, even when loads or shocks are applied in the vertical direction, for example.

Further, adhesives B are filled in a space from side end portion 2b of the image pickup element 2 to the position of an approximate height of the weir member 13, and thereby, an approximate total area of the side of the weir member becomes the object of adhesion to increase an area of adhesion, and fixation in the direction of an optical axis and that in the vertical direction are strengthened.

Since a length of projection of the weir member 13 toward the image pickup element 2 side is shorter than a distance between base board PC and image pickup element 2, and it is possible to fill adhesives B in the diagonal direction, which makes it easy to fill.

Since the optical member 1 and a surface of the image pickup element 2 in which the optical member 1 is provided are covered by an outer frame member such as lens barrel 4 and cover member 12, the optical member 1 and the image pickup element 2 are prevented and protected from sticking of dust and moisture coming from the outside of the image pickup device 400 and from damage such as cracks, thus, it is possible to eliminate an influence on image pickup information resulting from the conditions of the optical member 1 and the image pickup element 2.

Further, since the optical member 1 is fitted in the lens barrel 4 and is regulated in terms of a position, it is possible to provide the optical member 1 so that prescribed positioning can be conducted for the base board PC and for the image pickup element 2 provided on the base board PC, based on fixation of the lens barrel 4 at the prescribed position on the base board PC, and it is possible to prevent that the optical member 1 is deviated from prescribed positions of the base board PC and of the image pickup element 2 provided on the base board PC.

Incidentally, though the weir member 13 is one made of polyimide in the embodiment mentioned above, the invention is not limited to this, and it may also be made of a material identical to that of adhesives B. Further, the base board PC may either be a rigid base board or be a flexible base board. Incidentally, the base board PC and the weir member 13 may also be made of the same material, such as, for example, polyimide.

A length of projection of the weir member 13 toward the image pickup element 2 side is not limited to the foregoing, and it may also be the same as, for example, a length from the reverse side of the base board PC to the reverse side of the image pickup element 2. In this case, fixation in the vertical direction can further be strengthened.

Further, the sequence in the method of fixation between the base board PC and the image pickup element 2 is not limited to the foregoing. For example, the weir member 13 may also be mounted after the image pickup element 2 is fixed on the base board PC.

For example, the image pickup element 2 is fixed on the reverse side of the base board PC, and adhesives B are filled on the prescribed position between the reverse side of the base board PC and the surface side of the image pickup element 2, for example, on the circumference of joining portion J, and the adhesives thus filled are hardened by either one of heat and ultraviolet radiation for tentative fixation.

It is also possible to employ the structure wherein weir member 13 is arranged at the prescribed position of the base board PC on the adhesives B fixed tentatively, to harden the adhesives B fixed tentatively for regular fixation.

In this case, the weir member 13 can be arranged after adhesives B are filled in a space between the base board PC and the image pickup element for tentative fixing, which makes it easy to fill adhesives 13.

Further, lower leg portion 1f representing a portion to be fit that is formed on optical member 1 is made so that its section is in a D-shaped form substantially. However, the invention is not limited to this, and other shapes for fitting can also be used.

In addition, it is naturally possible to modify the specific and detailed structures according to circumstances.

In the invention described in Structure (18), a weir member is provided to be projected from the surface side of the image pickup element on the outside of the connecting member on the reverse side of the base board, and adhesives are filled in a space between the connecting member and the weir member, and therefore, the fixing strength between the base board and the image pickup element is enhanced in both of the direction of an optical axis of the base board and the image pickup element and the direction perpendicular to the direction of an optical axis (hereinafter referred to as vertical direction). Namely, adhesives can be applied not only on the connecting member but also on the weir member, and thereby, an area of adhesion is increased, and strength of adhesion in the vertical direction is increased. Owing to this, even when a load or a shock is applied in the vertical direction, it is possible to prevent that the load is concentrated on the connecting member, namely, the point of joining between bonding pad BP and bump 12, namely, on an electric joining point between the base board and the image pickup element, and it is possible to prevent that the load is concentrated on the electric joining point between the base board and the image pickup element, and thereby, the connecting member is destroyed or troubles are caused on the electric connection.

In the invention described in Structure (19), the same effects as those in the invention described in Structure (18) can naturally be obtained, and in particular, adhesives are filled in a space between a side end portion of the image pickup element and the weir member, and thereby, an area of adhesion is increased, and fixing in the direction of an optical axis and fixing in the direction perpendicular to the direction of an optical axis are strengthened.

In the invention described in Structure (20), the same effects as those in the invention described in Structure (18) or Structure (19) can naturally be obtained, and in particular, the weir member is a frame-shaped member and it is arranged on the base board so that an image pickup element is positioned in the frame, thus, adhesives can be filled in the total area outside the image pickup element and thereby, fixing can be strengthened, and manufacturing is easy, compared with an occasion for providing a plurality of weir members.

In the invention described in Structure (21), the same effects as those in the invention described in either one of Structures (18) - (20) can naturally be obtained, and in particular, a length of the projected weir member is shorter than a distance between the reverse side of the base board and the reverse side of the image pickup element, thus, adhesives can be filled in the diagonal direction, which makes it easy to fill.

In the invention described in Structure (22), the same effects as those in the invention described in either one of Structures (18) - (21) can naturally be obtained, and in particular, the optical member is mounted on the surface side of the base board so that the optical member may come in contact with a surface of the image pickup element through the opening portion, thus, it is possible to stabilize dimensional accuracy of the optical member, and to attain a prescribed optical function by making a focusing position of the optical member to be an appropriated position, thereby, it is possible to make adjustment of focusing position and a tilt for the optical member to be unnecessary in the course of incorporating and after the incorporating.

Further, for the image pickup element mounted on the reverse side of the base board to correspond to the opening portion in terms of position, the optical member that converges incident light on the image pickup element is mounted through the opening portion from the surface side of the base board so that the optical member may touch a surface of the image pickup element. Therefore, the image pickup device can be formed to be thinner by an amount equivalent to a thickness of the base board, which realizes a thinner image pickup device.

In the invention described in Structure (23), the same effects as those in the invention described in either one of Structures (18) - (22) can naturally be obtained, and in particular, an adhesive to be used is either one of a UV-setting type adhesive, a thermosetting type adhesive and a heat-UV-setting type adhesive, which makes it possible to fix the base board and the image pickup element together with adhesives.

In the invention described in Structure (24), adhesives are filled after the weir member and the image pickup element are mounted on the base board, and therefore, adhesives are interrupted by the weir member not to be filled in unnecessary portions, which is preferable, and adhesives are applied on not only connecting members but also the weir member to increase an area of adhesion, thus, fixing strength between the base board and the image pickup element is enhanced in both of the direction of an optical axis and the direction perpendicular to the direction of an optical axis.

In the invention described in Structure (25), the same effects as those in the invention described in Structure (24) can naturally be obtained, and in particular, in the fourth step, heat or ultraviolet radiation is radiated from the radiating means that is arranged so that heat or ultraviolet radiation may be radiated directly to adhesives filled from the outside of the opening portion into a space between the base board and the image pickup element through the opening portion, which makes it possible to harden adhesives without damaging an image pickup area when the image pickup area of the image pickup element is irradiated by heat or ultraviolet radiation.

The invention described in Structure (26) is characterized in that filling of adhesives in the third step and radiation of heat or ultraviolet radiation from the radiating means in the fourth step are conducted simultaneously in the manufacturing method for an image pickup device described in Structure (25).

In the invention described in Structure (26), the same effects as those in the invention described in Structure (25) can naturally be obtained, and in particular, filling of adhesives in the third step and radiation of heat or ultraviolet radiation from the radiating means in the fourth step are conducted simultaneously, therefore, it is possible to reduce the manufacturing time and to prevent that adhesives flow out to unnecessary portions and adhesives are filled beyond what is necessary.

In the invention described in Structure (27), filling of adhesives is easy because the weir member can be arranged after filling adhesives in a space between the base board and the image pickup element for fixing them tentatively.

In the invention described in Structure (28), a portable terminal wherein an image pickup device described in either one of Structures (18) - (23) is housed can be made small based on the image pickup device.

## Claims

1. An image pickup device comprising:
(a) a base board on which an opening portion is formed;
(b) an image pickup element provided on a reverse side of the base board so that at least a part of the opening portion is covered;
(c) an optical member for converging light incident on the image pickup element, the optical member being provided so as to come in contact with a front surface of the image pickup element from the front surface of the base board through the opening portion; and
(d) an outer frame member provided on the base board to cover the optical member and the opening portion.

2. The image pickup device of claim 1, wherein the optical member comprises a portion to be engaged that is inter fitted in the outer frame member to prevent that the optical member rotates about an optical axis of the optical member, and the outer frame member comprises an engaging portion that is interfitted in the portion of the optical member.

3. The image pickup device of claim 1 or 2, wherein the optical member comprises a first optical member that comes in contact with a surface of the image pickup element, and at least one auxiliary optical member which is stacked on the first optical member so that an optical axis of the auxiliary optical member agrees with an optical axis of the first optical member.

4. The image pickup device of claim 1, 2 or 3, wherein the base board has electric parts thereon for processing an image.

5. The image pickup device of claim 1, 2 or 3, wherein prescribed electric parts are arranged on the base board that is covered by the outer frame member.

6. The image pickup device of claim 4, wherein at least a part of the electric parts is arranged in the vicinity of a fixed position at which the outer frame member is fixed.

7. The image pickup device of claim 4, wherein a photoelectric conversion section is provided on the front surface at a position corresponding to the opening portion to convert incident light to an electric signal, and the optical member is arranged to focus an object image by converging the incident light onto the photo-electric conversion section.

8. The image pickup device of any one of claims 1 to 7, wherein the base board is a flexible base board, and the opening portion is formed in a way that each corner portion of an approximate polygon of the opening portion is cut off outwardly.

9. An image pickup device comprising:
(a) a flexible base board equipped with an opening portion;
(b) an image pickup element mounted on a reverse side of the flexible base board so that a part of the opening portion is covered and an image pickup area is exposed to an outside; and
(c) an optical member for converging incident light on the image pickup area of the image pickup element, wherein the opening portion is formed in a way that each corner portion of an approximate polygon of the opening portion is cut off outwardly.

10. The image pickup device of claim 8 or 9, wherein each of four corner portions of an approximate rectangle of the opening portion is formed to be in a cutout form outwardly.

11. The image pickup device of claim 8, 9 or 10, wherein the cutout portion of the opening portion is formed to be tapered off toward an outer edge portion of the flexible base board.

12. The image pickup device of any one of claims 8 to 11, wherein the cutout portion of the opening portion is a circular form approximately, and the optical member is structured to touch a surface of the image pickup element through the cutout portion.

13. The image pickup device of any one of claims 8 to 12, wherein the image pickup element and an electric connecting portion are formed along an inner edge portion of the opening portion on the flexible base board.

14. The image pickup device of claim 13, wherein each cutout portion is formed to be closer to an outer edge side of the flexible base board than a point of intersection of two extended lines of the electric connecting portions formed respectively along adjoining inner edge portions is.

15. The image pickup device of any one of claims 8 to 14, wherein a difference in a coefficient of linear expansion between the flexible base board and the image pickup element is 25 -36 ppm/°C.

16. The image pickup device of any one of claims 1 to 15, further comprising:
a connecting member for connecting electrically the reverse side of the base board and a front side of the image pickup element which are spaced from each other; and
a weir member provided to be projected from the surface side of the image pickup element outside the connecting member on the reverse side of the base board,
wherein adhesives are filled in a space between the connecting member and the weir member.

17. An image pickup device comprising:
(a) a base board on which an opening portion is formed;
(b) an image pickup element mounted on a reverse side of the base board to cover at least a part of the opening portion;
(c) an optical member for converging incident light on the image pickup element;
(d) a connecting member for connecting electrically the reverse side of the base board and a front side of the image pickup element which are spaced from each other; and
(e) a weir member provided to be projected from the surface side of the image pickup element outside the connecting member on the reverse side of the base board,
wherein adhesives are filled in a space between the connecting member and the weir member.

18. The image pickup device of claim 16 or 17, wherein the weir member is provided outside a side end portion of the image pickup. element, and the adhesives are filled in a space between the side end portion of the image pickup element and the weir member.

19. The image pickup device of claim 16 or 17, wherein the weir member is a frame-shaped member, and is arranged on the base board so that the image pickup element is positioned inside the frame-shaped member.

20. The image pickup device of claim 16 or 17, wherein a length of the weir member in a projecting direction thereof is shorter than a distance between. the reverse side of the base board and the reverse side of the image pickup element.

21. The image pickup device of any one of claims 16 to 20, wherein the adhesives are either one of UV-setting type adhesives, thermosetting type adhesives and UV-heat setting type adhesives.

22. A portable terminal comprising:
(a) an image pickup device as defined in any one of claims 1 to 21; and
(b) a casing in which the image pickup device is provided.

23. A manufacturing method of an image pickup device defined in claim 1 combined with claim 16 or in claim 17, said manufacturing method comprising the steps of:
(a) arranging the weir member at a prescribed position on the base board;
(b) mounting the image pickup element on the reverse side of the base board through the connecting member so that an image pickup area of the image pickup element is exposed to the surface side of the base board from the opening portion;
(c) filling in a space between the weir member and the connecting member the adhesives which are set by at least one of heat and ultraviolet rays; and
(d) hardening the adhesives filled in a space between the weir member and the connecting member with at least either one of heat and ultraviolet rays.

24. The manufacturing method of claim 23, wherein the step of the hardening comprises radiating heat or ultraviolet rays from a radiating device arranged to be capable of radiating heat or ultraviolet rays directly on the adhesives filled in the space between the base board and the image pickup element through the opening portion from the outside of the opening portion.

25. The manufacturing method of claim 23 or 24, wherein the filling of adhesives and the radiating of heat or ultraviolet radiation from the radiating device are conducted simultaneously.

26. A manufacturing method of an image pickup device defined in claim 1 combined with claim 16 or in claim 17, said manufacturing method comprising the steps of:
(a) mounting the image pickup element on the reverse side of the base board through the connecting member so that an image pickup area of the image pickup element is exposed to the surface side of the base board from the opening portion;
(b) filling adhesives which are set by at least either one of heat and ultraviolet radiation at a prescribed position between the reverse side of the base board and the surface side of the image pickup element;
(c) hardening the adhesives filled in the space between the base board and the image pickup element by at least either one of heat and ultraviolet radiation for tentative fixing;
(d) arranging the weir member at the prescribed position on the base board on the adhesives fixed tentatively; and
(e) hardening the adhesives fixed tentatively for regular fixing.
